(19) Europäisches Patentamt
European Patent Office
Office européen des brevets

(11) **EP 2 082 079 B1**

(12) **EUROPÄISCHE PATENTSCHRIFT**

(45) Veröffentlichungstag und Bekanntmachung des Hinweises auf die Patenterteilung:
**18.09.2019 Patentblatt 2019/38**

(21) Anmeldenummer: **07803181.2**

(22) Anmeldetag: **03.09.2007**

(51) Int Cl.:
*C23C 28/04* (2006.01)   *C23C 30/00* (2006.01)
*C23C 14/08* (2006.01)

(86) Internationale Anmeldenummer:
**PCT/EP2007/059196**

(87) Internationale Veröffentlichungsnummer:
**WO 2008/043606 (17.04.2008 Gazette 2008/16)**

(54) **SCHICHTSYSTEM MIT ZUMINDEST EINER MISCHKRISTALLSCHICHT EINES MEHRFACHOXIDS**

LAYER SYSTEM HAVING AT LEAST ONE MIXED CRYSTAL LAYER OF A POLYOXIDE

SYSTÈME DE COUCHES AVEC AU MOINS UNE COUCHE DE CRISTAL MIXTE D'UN OXYDE MULTIPLE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **10.10.2006 CH 16142006**

(43) Veröffentlichungstag der Anmeldung:
**29.07.2009 Patentblatt 2009/31**

(73) Patentinhaber: **Oerlikon Surface Solutions AG, Pfäffikon**
**8808 Pfäffikon SZ (CH)**

(72) Erfinder:
• **RAMM, Jürgen**
**7304 Maienfeld (CH)**
• **WIDRIG, Beno**
**7310 Bad Ragaz (CH)**
• **ANTE, Michael**
**6830 Rankweil (AT)**
• **WOHLRAB, Christian**
**6800 Feldkirch (AT)**

(74) Vertreter: **Troesch Scheidegger Werner AG**
**Schwäntenmos 14**
**8126 Zumikon (CH)**

(56) Entgegenhaltungen:
**EP-A1- 0 513 662**     **WO-A-2004/097062**
**WO-A-2006/099758**     **DE-A1- 19 522 331**
**JP-A- 2000 129 445**    **US-A1- 2004 121 147**

• **JI A L ET AL: "Microstructures and mechanical properties of chromium oxide films by arc ion plating", MATERIALS LETTERS, NORTH HOLLAND PUBLISHING COMPANY. AMSTERDAM, NL, vol. 58, no. 14, 1 May 2004 (2004-05-01), pages 1993-1998, XP004502298, ISSN: 0167-577X, DOI: 10.1016/J.MATLET.2003.12.029**

## Beschreibung

Die Erfindung bezieht sich auf ein Werkstück mit einem PVD Schichtsystem gemäss dem Oberbegriff von Anspruch 1 sowie auf ein Verfahren zur Herstellung eines entsprechenden Schichtsystems auf einem Werkstück gemäss einem der Ansprüche 6 und 8.

## Stand der Technik

In EP 0513662 bzw. US 5 310 607 (Balzers) wird eine $(Al,Cr)_2O_3$-Hartstoffschicht, ein beschichtetes Werkzeug und ein Prozess zur Herstellung der Schicht beschrieben, wobei aus einem als Anode einer Niedervoltbogen(NVB)entladung geschalteten Tiegel Al und Cr Pulver gemeinsam verdampft und Werkzeuge in einer $Ar/O_2$-Atmosphäre bei ca. 500°C beschichtet werden. Die Schicht weist Druckeigenspannungen auf und besteht im Wesentlichen aus Mischkristallen mit einem Cr-Gehalt grösser 5%, wobei die thermodynamische Stabilität durch einen hohen Aluminiumgehalt, die Beständigkeit gegenüber abrasivem Verschleiss durch einen erhöhten Chromgehalt verbessert wird. Die Schicht wird zwar anhand einer angeblichen 202-Linie als Modifikation des $\alpha$-Aluminiumoxides (Korund) bezeichnet, die eine dem Chromgehalt entsprechende Verschiebung aufweist, jedoch fehlen bei diesen Auswertungen alle anderen Korundlinien. Trotz der beschriebenen Vorteile konnten sich diese Schichten nicht als industrieller Standard etablieren, da die Herstellung mit dem beschriebenen NVB-Verfahren auf Grund der isolierenden Schichteigenschaften im Dauerbetrieb zu prozesstechnischen Problemen führt.

Eine Umgehung solcher prozesstechnischer Probleme durch Abscheidung einer zumindest ausreichend leitfähigen Schicht eines ternären Nitrids und einem nachgeschalteten Oxidationsschritt wird in den folgenden drei Dokumenten beschrieben. Alle drei Dokumente zielen jedoch darauf ab, eine Oxidschicht bzw. Einlagerungen in Korundstruktur als Vorlage für das Aufwachsen einer $\alpha$-Aluminiumoxidschicht zur Verfügung zu stellen. Wobei letztere mittels Unbalanced-Magnetron-Sputtering (UBMS) in einer $Ar/O_2$-Atmosphäre mit aufwendiger Prozessüberwachung mittels Plasmaemissionsmonitor (PEM) hergestellt wird, um die Al-Sputtertargets in einem Übergangsbereich zwischen vergifteter also oxidischer und metallischer Oberfläche zu halten.

In US 6 767 627 und JP-No 2002-53946 (Kobe) wird ein Schichtsystem und eine Methode zur Herstellung eines $\alpha$-aluminiumoxidhaltigen Schichtsystems beschrieben. Dabei wird beispielsweise zunächst eine TiAlN- und eine AlCrN-Hartschicht aufgebracht, anschliessend zumindest die Oberfläche der AlCrN-Hartschicht oxidiert wodurch eine korundähnliche Gitterstruktur mit einer Gitterkonstante zwischen 0.4779 und 0.5 nm als Zwischenschicht entsteht. Darauf wird die $\alpha$-Aluminiumoxidschicht (a = 0.47587 nm) abgeschieden. Die Autoren behaupten dabei auch bei Temperaturen zwischen 300 und 500°C Schichten in Korundstruktur durch einen AIP-Prozesse mit nachfolgendem Oxidationsschritt und anschliessendem UBMS von Aluminiumoxid herstellen zu können. Alternativ werden noch Aluminiumoxidschichten offenbart die auf ebenfalls mit UBMS in $Ar/O_2$-Atmosphäre hergestellten $Cr_2O_3$, $(Al,Cr)_2O_3$ bzw. $(Fe,Cr)_2O_3$-Zwischen-schichten abgeschieden wurden. Weiters erwähnen die Autoren, mit Bezug auf JP5-208326, die schlechte Eignung von $(Al,Cr)_2O_3$ Schichten für die Bearbeitung von Stählen auf Grund der Reaktion des Chroms an der Oberfläche der Schicht mit dem Eisen des zu bearbeitenden Materials.

Demgegenüber erkennen Erfinder desselben Anmelders in der jüngeren US 2005 005 8850 (Kobe), dass diese Techniken tatsächlich Temperaturen von 650°C bis 800°C benötigen, da bei zu tiefer Temperatur die Oxidation nicht stattfindet. Tatsächlich werden aber lediglich Beispiele bei einer Temperatur von 700° und 750°C offenbart und eine Methode beansprucht bei der zumindest der Oxidationsschritt oder die Abscheidung des Aluminiumoxidfilms bei einer Temperatur von 700° und mehr ausgeführt wird. Bevorzugt werden dabei beide Prozessschritte bei derselben Temperatur durchgeführt. Weiters offenbaren die Erfinder das zusätzliche Aufbringen einer bevorzugt Ti-haltigen Diffusionsbarriere, wie beispielsweise TiN, TiC, TiCN u.a., um die bei diesen hohen Prozesstemperaturen auftretende schädliche Diffusion des Sauerstoffs durch die Oxidschicht in das Substrat zu verhindern.

Auch WO 2004 097 062 (Kobe) sieht Verbesserungsbedarf an der in JP-No 2002-53946 beschriebenen Erfindung. Ausgangspunkt ist dabei ein Versuch, bei dem analog zu JP-No 2002-53946 CrN bei 750°C oxidiert und anschliessend bei derselben Temperatur Aluminiumoxid durch einen PEM kontrollierten Sputterprozess in einer $Ar/O_2$-At-mosphäre abgeschieden wird. Dies führt zwar zu kristallinen, aber mit zunehmender Schichtdicke immer grobkörnigeren und somit zu rauhen Schichten. Dem versucht WO 2004 097 062 durch ein Verfahren abzuhelfen, bei dem das Kristallwachstum des Aluminiumoxids entweder in periodischen Abständen durch dünne Oxidschichten anderer ebenfalls in Korundstruktur aufwachsender Metalloxide, wie $Cr_2O_3$, $Fe_2O_3$, $(AlCr)_2O_3$, $(AlFe)_2O_3$, oder zumindest durch periodische Einlagerungen solcher Oxide unterbrochen wird. Dabei sollen die die anderen Metalloxide umfassenden Schichtbereiche kleiner 10, bevorzugt sogar kleiner 2% gehalten werden. Die langen Beschichtungszeiten zur Herstellung solcher Schichten, ca. 5 Stunden für 2 $\mu$m, scheinen allerdings für industrielle Prozesse wenig geeignet.

In einer Publikation von Ashenford [Surface and Coatings Technology 116-119 (1999) 699-704] wird das Wachstum von Aluminiumoxid der Korundstruktur und Chromoxid der Eskolaitestruktur im Temperaturbereich zwischen 300°C und 500°C beschrieben. Die Eskolaitestruktur des Chromoxids gleicht der Korundstruktur des Aluminiumoxids, besitzt allerdings etwas veränderte Gitterparameter. Das Ziel der mit einem MBE System im UHV durchgeführten Untersuchungen war es, Chromoxid in Korundstruktur als Kristallisationsvorlage für das Wachstum der Korundhochtemperaturphase des Aluminiumoxids zu benutzen. Der Sauerstoff wird dabei durch das Plasma angeregt, die Metalle getrennt von elementaren Quellen verdampft, die örtlich so angeordnet sind, dass die Materialflüsse gleichzeitig am Substrat auftreffen. Auf Stahlsubstraten konnte im untersuchten Temperaturbereich zwischen 300 und 500°C lediglich amorphes Aluminiumoxid abgeschieden werden, wohingegen Chromoxid, weitgehend unabhängig von der Vorbehandlung der Stahlsubstraten, als polykristalline Schicht in Eskolaitestruktur aufwächst. Reines $\alpha$-Aluminiumoxid konnte jedoch auch auf Eskolaitschichten nicht hergestellt werden, da in diesem Temperaturbereich ab einer Konzentration von grösser 35 at% Aluminium die Kristallstruktur innerhalb weniger Atomlagen zu amorphen Aluminiumoxid kippt. Diese praktischen Befunde wurden anschliessend durch Simulationsrechnungen an Hand eines halbempirsichen Modells bestätigt, die eine Destabilisierung des $\alpha$-Aluminiumoxides durch Sauerstofffehlstellen zugunsten der $\kappa$-Modifikation voraussagt.

In EP 0 744 473 B1 wird ein Sputterprozess beschrieben, der für Substrattemperaturen unter 700° C ein Schicht liefert, die aus der $\alpha$- und $\gamma$-Phase des Aluminiumoxids besteht, vollständig kristallin ist aber hohe Druckspannungen von mindestens 1 GPa aufweist. Als Zwischenschichten zwischen Werkzeug und Aluminiumoxidschicht werden Metallverbindungen mit O, N und C genannt.

In JP 2000 129445 wird die Herstellung von Mischoxidschichten mittels Aluminium und einem Übergansmetall der IV, V oder VI Nebengruppe offenbart, wobei zur Abscheidung der Schicht eine Vakuum-Funkenentladung verwendet und eine nicht näher gezeigte Korrundstruktur erzielt wird.

US 2004/121147 A1 offenbart ein PVD Schichtsystem zum Beschichten von Werkstücken. Das Schichtsystem umfasst eine Mischkristallschicht eines Mehrfachoxids, z. B. (Al,Cr)2O3.

Zusammenfassend kann gesagt werden, dass sich der Stand der Technik im Bereich der Herstellung von Oxiden in Korundstruktur mittels PVD-Verfahren seit weit mehr als 10 Jahren damit auseinandersetzt $\alpha$-Aluminiumoxidschichten herzustellen, um der im CVD-Bereich seit langem sehr erfolgreichen Schicht ein Äquivalent ohne die durch das CVD-Verfahren bedingten Nachteile bieten zu können. Die Verfahren sind jedoch so komplex, fehleranfällig und umständlich, dass bis heute lediglich von einem Hersteller eine amorphe Aluminiumoxidschicht, jedoch keine kristallinen und insbesondere keine $\alpha$-Aluminiumoxidschichten im Bereich der Werkzeugbeschichtung angeboten werden. Aus ähnlichen Gründen werden bis heute keine anderen reinen Oxidschichten, insbesondere dicke Oxidschichten angeboten, wenngleich u.a. das Angebot an Oxinitriden, Oxicarbonitriden und Ähnlichem zeigt, das im Werkzeugmarkt ein hoher Bedarf an thermochemisch resistenten Beschichtungen besteht.

## Definitionen

Unter **thermisch stabil** im Sinne der vorliegenden Erfindung werden Schichten verstanden, die an Luft in einem Temperaturbereich von Raumtemperatur bis zumindest 900° C, bevorzugt 1000° C und insbesondere 1100° C keine Änderungen in der Kristallstruktur und somit keine wesentlichen Änderungen des Röntgendiffraktogramms und somit der Gitterparameter erkennen lassen. Solche Schichten sind sofern sie eine entsprechende Grundhärte von zumindest 1500 HV, bevorzugt jedoch mindestens 1800 HV aufweisen für Werkzeuganwendungen mit hoher thermische Beanspruchung besonders interessant, da keine Phasenumwandlungsprozesse während des Bearbeitungsvorgangs zu erwarten sind und die Warmhärte gegenüber anderen Schichten deutlich besser ist.

Unter **spannungsfrei** werden Schichten verstanden, die mit im Folgenden näher beschriebenen Prüfverfahren höchstens geringe Druck- bzw. Zugspannungen aufweisen. Dadurch kann beispielsweise aus der Verschiebung des Netzebenenabstandes bzw. der Gitterkonstanten von (AlCr)$_2$O$_3$ Schichten durch lineare Interpolation zwischen den Gitterkonstanten der binären Verbindungen $\alpha$-Al$_2$O$_3$ und $\alpha$-Cr$_2$O$_3$ direkt auf den Al- bzw. Cr-Gehalt der Schicht geschlossen werden (Vegardsches Gesetz).

Dies steht im Gegensatz zu beispielsweise aus EP 0513662 bzw. EP 0744473 bekannten PVD-Verfahren. Die dort beschriebenen Schichten die durch den Einbau von Edelgasatomen, Gleichstrombias oder aus anderen Gründen verspannt aufwachsen weisen hohe Druckeigenspannungen im Bereich über ein GPa auf, die bei grösseren Schichtdicken oft zu Abplatzungen führen.

CVD-Schichten zeigen demgegenüber üblicherweise Zugspannungen, die auf Grund der unterschiedlichen thermischen Ausdehnungskoeffizienten der Schicht und des Grundmaterials beim Abkühlen von den verfahrenstypisch hohen Abscheidungstemperaturen entstehen. Beispielsweise sind für die Abscheidung von $\alpha$-Al$_2$O$_3$ gemäss US 2004202877 Temperaturen zwischen 950 und 1050° C notwendig. Dies ist, mit dem zusätzlichen Nachteil eines unvermeidlichen Gehalts an unerwünschten Zerfallsprodukten (beispielsweise Halogene) aus dem Abscheidungsprozess, der Hauptnachteil des CVD-Beschichtungsprozesses, da diese Spannungen zur Rissbildung, z.B. Kammrisse, führen und daher die Schichten beispielsweise für Bearbeitungsprozesse mit unterbrochenem Schnitt wenig geeignet sind.

Als **Mehrfachoxide** werden hier Verbindungen zumindest zweier oder mehrerer Metalle mit einem Oxid bezeichnet. Weiters werden darunter auch die Oxide eines bzw. mehrerer Metalle die zusätzlich ein bzw. mehrere Halbleiterelemente wie beispielsweise B oder Si umfassen, verstanden. Ein Beispiel solcher Oxide sind die als Spinelle bekannten kubischen Doppel- bzw. Mehrfachoxide des Aluminiums. Die vorliegende Erfindung bezieht sich aber auf Oxide, die eine dem $\alpha$-Aluminiumoxid isomorphe Struktur des Korundtyps der Zusammensetzung $(Me1_{1-x}Me2_x)_2O_3$ aufweisen, wobei Me1 und Me2 jeweils zumindest eines der Elemente Al, Cr, Fe, Li, Mg, Mn, Ti, Sb oder V umfasst und dabei die Elemente von Me1 und Me2 jeweils verschieden sind.

## Messmethoden

Im Folgenden werden einzelne Methoden und Geräte die zur Charakterisierung bestimmter Schichteigenschaften verwendet wurden zum Zweck der besseren Vergleichbarkeit kurz erwähnt.

## Röntgendiffraktionsmessungen

Für die Messungen der XRD-Spektren und der daraus berechneten Gitterkonstanten wurde ein D8 Röntgendiffraktometer von Bruker-AXS mit Göbel-Spiegel, Soller-Spalt und energiedispersivem Detektor verwendet.
Die einfache $\theta$-2$\theta$-Messung erfolgte in Bragg-Brentano-Geometrie mit Cu-k$\alpha$-Strahlung, kein streifender Einfall.
Winkelbereich: 20 bis 90°, mit rotierendem Substrat.
Messzeit: bei einer Verweilzeit von 4s auf 0.01° betrug die Messzeit 7h 46min (für 70°).

## Messung der Schichteigenspannungen

Für die Messungen der Schichteigenspannungen wurde einerseits die Biegestreifenmethode nach Stoney auf Hartmetallstäbchen (L=2r=20mm, $D_s$=0.5 mm, $E_s$=210 GPa, $\nu_s$=0.29) verwendet und die Schichtspannung nach folgender Formel berechnet:

$$\sigma = \frac{E_s * D_s^2}{3 * L^2 * d_f} * f$$

Mit $E_s$ ... Young Module des Substrats, $D_s$ ... Gesamtdicke Substrat, df ... Schichtdicke, f... Durchbiegung und f ... freie Balkenlänge
Zum Anderen wurde die Biegescheibenmethode verwendet und die Schichtspannung nach folgender Formel berechnet:

$$\sigma = \frac{E_s}{(1-v_s)} * \frac{D_s^2 * 8}{6 * L^2} * \frac{f}{d_f}$$

Mit L=2r=20mm, $D_s$=0.5 mm, $E_s$=210 GPa, $\nu_s$=0.29
Zusätzlich gibt auch die mittels Röntgendiffraktometrie ermittelte Abweichung der Messpunkte eines Mehrfachoxids von der durch das Vegard'sche Gesetz bestimmten Gerade einen Hinweis auf Eigenspannungen im Schichtverbund.

## Übersicht

Aufgabe der vorliegenden Erfindung ist es, die oben im Detail beschriebenen Nachteile des Standes des Technik zu verbessern und ein für Hochtemperaturanwendungen geeignetes Schichtsystem, das zumindest eine thermisch stabile oxidische Schicht enthält, sowie Werkstücke, insbesondere Werkzeuge und Bauteile, die durch das Schichtsystem geschützt sind, zur Verfügung zu stellen. Eine weitere Aufgabe ist es, ein Verfahren zur Herstellung des Schichtsystems anzugeben, dass es in einfacher und sicher reproduzierbarer Weise ermöglicht Werkstücke zu beschichten und die Eigenschaften des Schichtsystems für unterschiedliche Anwendungen einzustellen.
Die Aufgabe wird durch ein PVD Schichtsystem zum Beschichten von Werkstücken nach Anspruch 1 gelöst.
Diese sind Schichtsysteme bei denen Me1 Aluminium ist und Me2 zumindest eines der Elemente Cr, Fe, Li, Mg, Mn, Nb, Ti, Sb oder V umfasst und $0.2 \leq x \leq 0.98$, bevorzugt $0.3 \leq x \leq 0.95$ ist. Aluminium kommt hier als Element zur Erhöhung der Oxidationsbeständigkeit und der Warmhärte besondere Bedeutung zu. Allerdings stellt sich ein zu hoher Aluminiumgehalt besonders bei der Herstellung der Schichten als problematisch heraus, da solche Schichten, insbesondere bei tiefen Beschichtungstemperaturen zunehmend kleinere Kristallite bilden mit entsprechendem Intensitätsverlust der Reflexe im Röntgendiffraktoramm.
Um ein möglichst ungestörtes und spannungsfreies Aufwachsen der Schicht zu ermöglichen sollte der Gehalt an Halogenen und Edelgasen in der Mischkristallschicht jedenfalls weniger als 2% betragen. Dies kann dadurch erreicht werden, dass die Quellen mit einem Prozessgas betrieben werden welches zumindest zu 80%, bevorzugt zu 90%, insbesondere sogar zu 100% aus Sauerstoff besteht. Somit kann auch der Gehalt an Edelgas in der Mischkristallschicht mit maximal 0,1 at%, bevorzugt maximal 0,05 at% und / oder der Gehalt der Halogene mit maximal 0,5 at%, bevorzugt maximal 0,1 at% begrenzt werden, bzw. was der günstigste Fall ist, die Mischkristallschicht bevorzugt im Wesentlichen edelgas- und halogenfrei hergestellt werden.

Bezüglich des Aufbaus der Mischkristallschicht sind mehrere Varianten möglich. Beispielsweise kann die Schicht als Einzel- oder Mehrlagenschicht aus zumindest zwei verschiedenen alternierend abgeschiedenen Mehrfachoxiden ausgeführt werden. Alternativ kann ein Mehrfachoxid in alternierender Reihenfolge mit einem weiteren Oxid abgeschieden werden.

Als besonders hochtemperaturbeständig haben sich dabei Mehrfachoxide erwiesen die durch Arcverdampfen von Aluminiumchrom- und Aluminiumvanadiumlegierungen hergestellt wurden. Als weitere Oxide zur alternierenden Beschichtung mit Mehrfachoxiden zeigen Oxide in Korundstruktur, wie $Cr_2O_3$, $V_2O_3$, $Fe_2O_3$, $FeTiO_3$, $Ti_2O_3$, $MgTiO_2$ und natürlich besonders $\alpha$-$Al_2O_3$ gute Hochtemperatureigenschaften.

Bei der Herstellung des Schichtsystems hat es sich als vorteilhaft erwiesen, die Schichtspannungen der Mischkristallschicht gering zu halten, um auch die Abscheidung dicker Schichten, wie sie beispielsweise besonders für schnelle Drehbearbeitung metallischer Werkstoffe notwendig ist, zu ermöglichen. Sollen dem Schichtsystem zusätzlich noch Eigenschaften, bespielsweise auch definierte Eigenspannungseigenschaften für die Bearbeitung gehärteter Stähle, besondere Gleiteigenschaften zur besseren Spanabfuhr oder zur Verwendung auf Gleitelementen, verbesserte Haftung für unterschiedliche Substrate oder ähnliches eingeprägt werden, können diese beispielsweise durch geeignete Wahl von zwischen dem Substrat und der Mischkristallschicht angeordneten, beispielsweise aus zumindest einer Haft- und / oder Hartschicht bestehenden Zwischenschichten, bzw. durch Aufbringen einer oder mehrerer Deckschichten auf die Mischkristallschicht erzielt werden.

Die Hartschicht bzw. Deckschicht enthält dabei vorzugsweise zumindest eines der Metalle der Nebengruppen IV, V, und VI des Periodensystems bzw. Al, Si, Fe, Co, Ni, Co, Y, La bzw. Verbindungen der genannten Elemente mit N, C, O, B oder Mischungen davon, wobei Verbindungen mit N, bzw. CN bevorzugt sind. Als besonders geeignet für die Hartschicht haben sich dabei die Verbindungen TiN, TiCN, AlTiN, AlTiCN, AlCrN bzw. AlCrCN erwiesen, während sich für die Deckschicht besonders AlCrN, AlCrCN, $Cr_2O_3$ oder $Al_2O_3$, insbesondere $\gamma$-$Al_2O_3$ oder $\alpha$-$Al_2O_3$ Verbindungen eignen. Ähnlich wie die Mischkristallschicht können auch die Zwischenschicht und / oder die Hartschicht eine Mehrlagenschicht umfassen. Weiters kann das Schichtsystem auch als Mehrlagenschicht mit alternierender Zwischenschicht und Mischkristallschicht bzw. alternierende Deckschicht und Mischkristallschicht aufgebaut sein.

Für die Herstellung von Mischkristallen in Korundstruktur eignen sich Arcverfahren mit speziell ausgelegtem kleinem senkrechten Magnetfeld und pulsüberlagerte Arcverfahren, sowie allgemein Verfahren bei denen an die Materialquellen, also Arcverdampfer Hochstromimpulse angelegt, bzw. dem DC-Grundbetrieb überlagert werden. Damit ist ein Betrieb im vergifteten Zustand, bzw. eine Legierungsbildung am Target möglich, sofern gewisse unten näher erläuterte Randbedingungen eingehalten werden.

Bezüglich der Arcverfahren zur Herstellung des erfindungsgemässen Schichtsystems sei zusätzlich noch auf folgende Anmeldungen desselben Anmelders verwiesen, die bezüglich des Verfahrens den nächsten Stand der Technik bilden: WO 2006099758, WO 2006/099760 sowie CH 01166/06. Alle Verfahren wurden in einem RCS-Beschichtungssystem der Firma Balzers durchgeführt.

Für die Herstellung von Mischkristallen in Korundstruktur ist es bei allen Verfahren wesentlich, dass das Target ein Legierungstarget ist, da es sonst bei Abscheidetemperaturen unter 650°C, wie unten näher beschrieben nicht gelingt, oxidische Mischkristallschicht in Korundstruktur abzuscheiden. Im Sinne eines möglichst einfach reproduzierbaren Verfahrens ist es vorteilhaft, die Verfahrensparameter so zu wählen, dass sich die Zusammensetzung der Metalle der Mischkristallschicht, nach Normierung auf den Gesamtmetallgehalt, bezüglich der entsprechenden Metallanteile um nicht mehr als 10 bevorzugt um nicht mehr als 5, insbesondere nicht mehr als 3 Prozent vom Gehalt der metallischen Targetzusammensetzung unterscheidet. Dies gelingt beispielsweise durch Einhaltung der in den Versuchsbeispielen genannten Parameter, durch Wahl eines eher niedrigen Substratbias, beispielsweise unter 100 V, um eine Entmischung durch Kanteneffekte u.ä. zu verhindern. Diese können auch vom Fachmann, je nach Legierungssystem angepasst und variiert werden, beispelsweise falls bei Bedarf sehr hohe Druckspannung erzielt werden sollen.

Arcverfahren bei denen an der Oberfläche des Targets kein oder nur ein kleines, im Wesentlichen zur Targetoberfläche senkrechtes, äusseres Magnetfeld, angelegt wird sind prinzipiell für die Herstellung erfindungsgemässer Mehrfachoxide geeignet. Wird ein Magnetfeld mit einer senkrechten Komponente $B_z$ angelegt, ist es vorteilhaft die radiale oder oberflächenparallele Komponente $B_r$ zumindest über den Grossteil der Targetoberfläche, zumindest aber über 70%, bevorzugt 90% kleiner als $B_z$ einzustellen. Die senkrechte Komponente $B_z$ wird dabei zwischen 3 und 50 Gauss, bevorzugt jedoch zwischen 5 und 25 Gauss eingestellt. Solche Magnetfelder können beispielsweise mit einem aus zumindest einer axial gepolten Spule bestehenden Magnetsystem, das eine dem Targetumfang ähnliche Geometrie aufweist, erzeugt werden. Die Spulenebene kann dabei in Höhe der Targetoberfläche oder bevorzugt parallel dahinter angeordnet werden. Die im Folgenden näher beschriebenen Verfahren mit gepulsten Quellen können besonders vorteilhaft als Arcverfahren mit Quellen die ein solches schwaches Magnetfeld aufweisen, alternativ jedoch auch ohne Magnetfeld, betrieben werden.

Bei den folgenden Pulsquellenverfahren zur Herstellung von insbesondere thermisch stabilen Mischkristallschichten von Mehrfachoxiden im Kristallgitter des Korundtyps wird zumindest eine Arcquelle gleichzeitig mit einem Gleichstrom als auch mit einem Puls- bzw. Wechselstrom gespeist. Dabei wird mit einer als Legierungstarget ausgeführten ersten Elektrode einer Arcquelle sowie mit einer zweiten Elektrode eine Schicht auf das Werkstück abgeschieden, wobei die Quelle gleichzeitig mit einem Gleichstrom bzw. Gleichspannung als auch mit einem Puls- oder Wechselstrom bzw. einer Puls- oder Wechselspannung gespiesen wird. Das Legierungstarget entspricht dabei im Wesentlichen der Zusammensetzung der Mischkristallschicht. Die bevorzugte Pulsfrequenz liegt dabei in einem Bereich von 1kHz bis 200kHz, wobei die Pulsstromversorgung auch mit einem unterschiedlichen Pulsbreitenverhältnis, bzw. mit Pulspausen, betrieben werden kann.

Die zweite Elektrode kann dabei von der Arcquelle getrennt oder als Anode der Arcquelle angeordnete sein, wobei die erste und die zweite Elektroden mit einer einzelnen Pulsstromversorgung verbunden, betrieben werden. Wird die zweite Elektrode nicht als Anode der Arcquelle betrieben, kann die Arcquelle über die Pulsstromversorgung mit einer der folgenden Materialquelle verbunden bzw. betrieben werden:

- Einer weiteren Arcverdampferquelle, die ebenfalls mit einer DC-Stromversorgung verbunden ist;

- Einer Kathode einer Sputterquelle, insbesondere einer Magnetronquelle, die ebenfalls mit einer Stromversorgung, insbesondere mit einer DC-Stromversorgung verbunden ist;

- Einem Verdampfungstiegel der gleichzeitig als Anode eines Niedervoltbogenverdampfers betrieben wird.

Die DC-Stromversorgung erfolgt dabei mit einem Grundstrom so, dass die Plasmaentladung zumindest an den Arcverdampferquellen, bevorzugt jedoch an allen Quellen im wesentlichen unterbrechungsfrei aufrechterhalten wird.

Vorteilhafterweise wird dabei jeweils die DC-Stromversorgung und die Pulsstromversorgung mit einem elektrischen Entkopplungsfilter entkoppelt das vorzugsweise mindestens eine Sperrdiode enthält. Die Beschichtung kann dabei bei Temperaturen kleiner 650°C , bevorzugt kleiner 550°C erfolgen.

Die Mehrfachoxidschichten wachsen in diesem Fall trotz der verhältnismässig niedrigen Beschichtungstemperatur und eventueller als Haft oder Zwischenschicht darunterliegenden beispielsweise kubischen Metallnitrid oder Karbonitridschicht in korundartiger Struktur auf, was überrascht, da bei vorhergehenden Versuchen, bei denen Schichten durch simultanes Bedampfen der Werkstücke mittels elementarer Aluminium- und Chromtargets unter Sauerstoff lediglich amorphe, beispielsweise $(Al_{1-x}Cr_x)_2O_3$ Schicht hergestellt werden konnten. Dies war auch dann der Fall, wenn der Beschichtungsbereich der Quellen überlappend eingestellt wurde. Erst durch die Verwendung von Legierungstargets ist es möglich bereits bei verhältnismässig niedrigen Prozesstemperaturen Mehrfachoxide in kristalliner, insbesondere in Korundstruktur abzuscheiden. Dabei ist zusätzlich darauf zu achten, dass am Target genügend Sauerstoff zur Verfügung steht, weshalb ein hoher Sauerstoffgehalt von zumindest 80%, bevorzugt 90% im Prozessgas eingestellt bzw. wie im nachfolgenden Beispiel 1) ausschliesslich Sauerstoff als Prozessgas verwendet wird. Die Targetoberfläche wird dabei während des Arcprozesses sofort mit einer dünnen nichtleitenden Schicht überzogen. Nach Ansicht der Erfinder könnte der Grund für das Herabsetzen des sonst erst bei wesentlich höhen Temperaturen möglichen kristallinen Schichtwachstums, insbesondere des Wachstums in Korundstruktur auf eine Bildung von Mehrfachoxiden auf der Targetoberfläche zurückzuführen sein, die während des Prozesses verdampfen, zunächst Wachstumskeime auf dem Werkstück bilden und schliesslich am Schichtaufbau beteiligt sind. Auf einen solchen Wachstumsmechanismus kann aus mehreren Günden geschlossen werden. Einerseits liegen die durch den Funken erzeugten Temperaturen auf der Targetoberfläche im Bereich des Schmelzpunktes der Legierung, womit bei ausreichend hoher Sauerstoffkonzentration gute Voraussetzungen für die Bildung von hochtemperaturstabilen korundartigen Mehrfachoxidstrukturen vorliegen. Andererseits konnten wie oben erwähnt beim simultanen Verdampfen von elementaren Aluminium- und Chromtargets keine Mischkristalle hergestellt werden. Ähnliches gilt auch für mittels Sputtertechnik hergestellte Oxidschichten. So wurden bei zu US 6 767 627 analogen Versuchen durch die Erfinder der vorliegenden Anmeldung Aluminiumoxid- und Aluminiumchromoxidschichten in einem Temperaturbereich zwischen 400 und 650 °C mittels Sputtern hergestellt. Es konnten jedoch keine kristallinen Aluminiumoxid- bzw. Aluminiumchromoxidschichten mit Korundstruktur nachgewiesen werden. Dies gelang auch bei Verwendung von Lergierungstargets nicht, was einerseits auf die beim üblichen Sputterverfahren fehlende thermische Anregung auf der Substratoberfläche hindeuten könnte, andererseits auf die Tatsache, dass von der Targetoberfläche keine Verbindungen gesputtert werden, sondern nur Atome.

Wenn auch ein praktischer Beweis eines solchen Bildungsmechanismus, beispielsweise durch Spektralanalyse, an dieser Stelle nicht erbracht werden kann und möglicherweise auch andere Mechanismen von Bedeutung sind, ist doch festzustellen, dass es mit vorliegender Erfindung erstmals gelingt Mehrfachoxide mit eindeutig nachgewiesener Korundgitterstruktur bei einer Beschichtungstemperatur zwischen 450 und 600°C herzustellen.

Um die thermische Anregung auf der Targetoberfläche weiter zu erhöhen wurden auch einzelne Versuche mit ungekühlten, bzw. mit geheizten Targets gefahren und unter Sauerstoff von der bald rot glühenden Targetobefläche Material verdampft. Auch die so hergestellten Schichten zeigen ein Gitter vom Korundtyp. Gleichzeitig kann bei solchen Prozessen an Hand des Anstiegs der Entladungsspannung eine Erhöhung der Plasmaimpedanz festgestell werden, die auf die erhöhte Elektronenemission glühender Oberflächen in Kombination mit erhöhtem Dampfdruck des Targetmaterials zurückzuführen ist und durch das Pulsen des Quellenstroms noch verstärkt wird.

Eine weitere Möglichkeit zur Herstellung erfindungsgemässer Oxidschichten ist das Betreiben einer Hochleistungsentladung mit zumindest einer Quelle. Diese kann beispielsweise durch Betreiben der Pulsstrom- bzw. Pulsspannungsversorgungen mit einer Pulsflankensteilheiten die mindestens im Bereich von 0,02 V/ns bis 2,0 V/ns, vorzugsweise im Bereich von 0,1 V/ns bis 1,0 V/ns liegt erzeugt werden. Dabei werden Ströme von zumindest 20 A, bevorzugt jedoch gleich oder grösser 60A, bei Spannungen zwischen 60 und 800 V, bevorzugt zwischen 100 und 400 V über bzw. zusätzlich zu Spannung und Strom der gleichzeitig betriebenen DC-Entladung angelegt. Diese Spannungsnadelimpulse können beispielsweise durch eine oder mehrere Kondensatorkaskaden erzeugt werden, was neben verschiedenen anderen Vorteilen es auch ermöglicht die Grundstromversorgung zu entlasten. Bevorzugt wird aber der Pulsgenerator zwischen zwei gleichzetig mit DCbetriebenen Arcquellen geschaltet. Überraschenderweise gelingt es durch das Anlegen der Nadelimpulse im Arcverfahren die Spannung an der Quelle über mehrere μs in Abhängigkeit von der Höhe des angelegten Spannungssignals zu erhöhen, wohingegen Pulse mit geringerer Flankensteilheit sich wie zu erwarten lediglich in einer Erhöhung des Quellenstroms auswirken.

Wie erste Versuche gezeigt haben ist es mit solchen Hochstromentladungen auch möglich von Sputterquellen mit Legierungstargets oxidische Mehrfachoxide in Korund-, Eskolait- oder vergleichbaren hexagonalen Kristallstrukturen herzustellen, was vermutlich auf die erhöhte Leistungsdichte an der Oberfläche des Targets und der damit einhergehenden starken Temperaturerhöhung zurückzuführen ist, auch hier könnte die Verwendung ungekühlter oder beheizter Targets wie oben beschrieben vorteilhaft sein. Die Hochleistungsentladung zeigt für solche Prozesse sowohl für das Hochleistungsarcen als auch für das Hochleistungssputtern ähnliche Charakteristika, wie sie der aus dem Townsend-Strom-Spannungs-Diagramm bekannten anormalen Glimmentladung entsprechen. Die Annäherung an diesen Bereich geschieht dabei jeweils von entgegengesetzten Seiten, daher einserseits von der Bogenentladung des Arcverfahrens (niedrige Spannung, hoher Strom), andererseits von der Glimmentladung des Sputterverfahrens (mittlere Spannung, kleiner Strom).

Grundsätzlich sind, wenn man sich dem Bereich der anormalen Glimmentladung von der Hochstromseite, daher von der "Arcseite" nähern will Massnahmen zur Impedanzerhöhung des Plasmas bzw. der Targetoberfläche (s.o.) notwendig. Dies kann, wie oben beschrieben durch Überlagerung von Nadelimpulsen, durch Erhitzen der Targetoberfläche oder durch eine Kombination der Massnahmen bewirkt werden.

Eine weitere Möglichkeit zur Erhöhung der Plasmaimpedanz ergibt sich durch das Pulsen eines Quellenmagnetfeldes. Dies kann beispielsweise durch den Pulsstrom der Quelle erfolgen, der entweder zur Gänze oder nur als Teilstroms durch ein wie oben beschriebenes aus einer axial gepolten Spule bestehendes Magnetsystem geleitet wird. Entsprechend der hohen auftretenden Stromspitzen können hier bei Bedarf gekühlte Spulen mit geringer Windungszahl (1 bis 5) verwendet werden.

Aus dem oben Angeführten und den unten beschrieben Versuchen ist zu erkennen, dass erfindungsgemässe Schichtsysteme ganz allgemein eine ausgezeichnete Eignung für Werkzeuganwendungen aufweisen. Vorteilhaft können daher die Schichtsysteme auf Werkzeuge wie Fräser, Bohrer, Verzahnungswerkzeuge, Wendeschneidplatten, Abstechmesser, Räumnadeln aus unterschiedlichen Werkstoffen wie beispielsweise Kalt- und Warmarbeitsstählen, HSS-Stahl sowie Sinterwerkstoffen wie pulvermetallurgischen(PM) Stahl, Hartmetall (HM), Cermets, kubischem Bornitrid (CBN), Siliziumcarbid(SiC) bzw. Siliziumnitrid(SiN) aufgebracht werden. Besonders gut ist jedoch die Eignung für Werkzeuganwendungen mit hohen Bearbeitungstemperaturen bzw. Schnittgeschwindigkeiten wie zum Beispiel Drehoperationen, Hochgeschwindigkeitsfräsen und Ähnliches, die neben der abrasiven Belastung auch hohe Anforderungen bezüglich der thermochemischen Stabilität der Hartschicht stellen. Für solche Werkzeuge werden heute vor allem CVD-beschichtete Wendeschneidplatten verwendet. Dabei werden häufig Schichtdicken im Bereich zwischen 10 und 40 μm eingesetzt. Auf Grund der oben beschriebenen Eigenschaften sind beschichtete Wendeschneidplatten daher eine bevorzugte Anwendung der erfindungsgemässen Schichten. Insbesondere Wendeschneidplatten aus PM-Stahl, Hartmetall-, Cermet-, CBN-, SiC-, SiN-Sinterwerkstoffen oder mit plykristallinem Diamant vorbeschichtete Wendeschneidplatten

Obwohl bei der Arbeit an der vorliegenden Erfindung vor allem die Entwicklung von Schutzschichten für spanende Werkzeuge im Vordergrund stand, können die Schichten selbstverständlich auch in anderen Bereichen vorteilhaft eingesetzt werden. Beispielsweise kann eine gute Eignung für Werkzeuge für verschiedene Warmumformprozesse, wie Form- und Gesenkschmieden oder Spritzgiessen von Metallen bzw. Legierungen angenommen werden. Auf Grund der hohen chemischen Resistenz können die Schichten auch auf Werkzeugen für die Kunststoffverarbeitung beispielsweise Spritz- oder Presswerkzeuge für Formteile eingesetzt werden.

Weitere mögliche Anwendungen ergeben sich im Bereich der Beschichtung von Bauteilen und Komponenten, wie zum Beispiel dem Einsatz auf temperaturbelasteten Bauteilen von Verbrennungskraftmaschinen wie Einspritzdüsen, Kolbenring, Tassenstössel, Turbinenblätter und ähnlich belastete Komponenten. Auch hier können ähnlich wie oben, zumindest in den dem Verschleiss ausgesetzten Bereichen, folgende Grundmaterialien verwendet werden: Kaltarbeitsstahl, HSS, PM-Stahl, HM-, Cermet- oder CBN-Sinterwerkstoffe.

Auch für temperaturstabile Sensorschichten können Schichten mit dem erfindungsgemässen Verfahren abgeschieden werden, beispilesweise für piezo- und ferroelektrische Materialien bis hin zu quarternären supraleitenden Oxidschichten. Es versteht sich von selbst, dass diese Schichten nicht an eine Struktur des Substrates gebunden sind und dass sich in solchem Zusammenhang vor allem eine Applikation in Verbindung mit MEMS auf Siliziumbasis anbieten.

**Beispiele und Figuren**

Die Erfindung wird anschliessend anhand von Beispielen erläutert, wobei auf die beispielhaft gezeigten Figuren Bezug genommen wird, welche Folgendes zeigen:

Fig.1    Röntgenspektren von $(Al_{1-x}Cr_x)O_3$-Schichten;
Fig.2    Gitterparameter von $(Al_{1-x}Cr_x)_2O_3$-Schichten;
Fig.3    Temperaturverhalten der Gitterparameter;
Fig.4    Oxidationsverhalten TiAlN-Schicht;
Fig.5    Oxidationsverhalten TiCN-Schicht ;
Fig.6    Oxidationsverhalten TiCN / $(Al_{1-x}Cr_x)_2O_3$-Schicht ;
Fig.7    Detail $(Al_{1-x}Cr_x)_2O_3$-Schicht ;

In dem im folgenden näher beschriebenen Versuch 1) wird ein vollständiger Ablauf eines erfindungsgemässen Beschichtungsverfahren mit einem schwachen im Wesentlichen senkrechten Magnetfeld im Bereich der Targetoberfläche gegeben.

Nach Einlegen der Werkstücke in dafür vorgesehenen zwei- oder dreifach rotierbare Halterungen und Einbringen der Halterungen in die Vakuumbehandlungsanlage, wird die Behandlungskammer auf einen Druck von ca. $10^{-4}$ mbar abgepumpt.

Zur Einstellung der Prozesstemperatur wurde ein durch Strahlungsheizungen unterstütztes Niedervoltbogen(NVB)plasma zwischen einer durch eine Blende abgetrennte Kathodenkammer mit Heisskathode und den anodisch geschalteten Werkstücken in einer Argon-Wasserstoffatmosphäre gezündet.

Dabei wurden folgende Heizparameter eingestellt:

| | |
|---|---|
| Entladestrom NVB | 250 A |
| Argonfluss | 50 sccm |
| Wasserstofffluss | 300 sccm |
| Prozessdruck | $1.4 \times 10^{-2}$ mbar |
| Substrattemperatur | ca. 550°C |
| Prozesszeit | 45 min |

Alternativen dazu sind dem Fachmann bekannt. Die Substrate wurden dabei bevorzugt als Anode für den Niedervoltbogen geschaltet und bevorzugt zusätzlich unipolar oder bipolar gepulst.

Als nächster Prozessschritt wird das Aetzen gestartet. Dafür wird der Niedervoltbogen zwischen dem Filament und der Hilfsanode betrieben. Auch hier kann eine DC, eine gepulste DC oder eine mit Wechselstrom betriebene MF oder RF Versorgung zwischen Werkstücken und Masse geschaltet werden. Bevorzugt wurden die Werkstücke aber mit einer negativen Biasspannung beaufschlagt.

Dabei wurden folgende Ätzparameter eingestellt:

| | |
|---|---|
| Argonfluss | 60 sccm |
| Prozessdruck | $2.4 \times 10^{-3}$ mbar |
| Entladestrom NVB | 150 A |
| Substrattemperatur | ca. 500°C |
| Prozesszeit | 45 Min |
| Bias | 200 - 250 V |

Im nächsten Prozessschritt erfolgt die Beschichtung des Substrates mit einer AlCrO-Schicht und einer TiAlN-Zwischenschicht. Alle Beschichtungsprozesse können bei Bedarf an erhöhter Ionisation noch durch das Plasma des Niedervoltbogens unterstütz werden.

Dabei wurden folgende Parameter bei Abscheidung der TiAlN-Zwischenschicht eingestellt:

| | |
|---|---|
| Argonfluss | 0 sccm (ohne Argonzugabe) |
| Stickstofffluss | Druckgeregelt auf 3 Pa |
| Prozessdruck | $3\times10^{-2}$ mbar |
| DC Quellenstrom TiAl | 200 A |
| Spulenstrom des Quellen-Magnetfeldes (MAG 6) | 1 A |
| DC Substratbias | U = -40 V |
| Substrattemperatur | ca. 550° C |
| Prozesszeit | 120 Min |

Für den ca. 15 min langen Übergang zur eigentlichen Funktionsschicht werden die AlCr-Arcquellen mit einem DC-Quellenstrom von 200 A zugeschaltet, wobei der positiven Pol der DC-Quelle mit dem Anodenring der Quelle und Masse verbunden ist. An die Substrate wird ein DC Substratbias von -40 V während dieses Schrittes angelegt. 5 Minuten nach dem Einschalten der AlCr(50/50)-Targets wird mit dem Sauerstoffeinlass begonnen, wobei dieser innert 10 Min von 50 auf 1000 sccm, gerampt wird. Gleichzeitig werden die TiAl(50/50)-Targets ausgeschaltet und der $N_2$ auf ca. 100 sccm zurückgeregelt. Kurz vor Einlass des Sauerstoffs wir der Substratbias von DC auf bipolares Pulsen umgeschaltet und auf U = -60 V erhöht. Damit sind die Zwischenschicht und der Uebergang zur Funktionsschicht fertiggestellt. Bei den Targets handelt es sich um pulvermetallurgisch hergestellte Targets. Alternativ können auch schmelzmetallurgische Targets verwendet werden. Um die Spritzerhäufigkeit herabzusetzen können einphasige Targets, wie in DE 19522331 beschrieben, verwendet werden.

Die Beschichtung der Substrate mit der eigentlichen Funktionsschicht erfolgt im reinen Sauerstoff. Da es sich bei Aluminiumoxid um isolierende Schichten handelt, wird entweder eine gepulste oder eine AC Biasversorgung verwendet.

Die wesentlichen Funktionsschichtparameter wurden dabei wie folgt eingestellt:

| | |
|---|---|
| Sauerstofffluss | 1000 sccm |
| Prozessdruck | $2.6\times10^{-2}$ mbar |
| DC Quellenstrom AlCr | 200 A |
| Spulenstrom des Quellen-Magnetfeldes (MAG 6) | 0.5 A, damit wurde an der Targetoberfläche ein im Wesentlichen senkrechtes schwaches Feld von ca. 2 mT (20 Gs) erzeugt. |
| Substratbias | U = 60 V (bipolar, 36 $\mu$s negativ, 4 $\mu$s positiv) |
| Substrattemperatur | ca. 550° C |
| Prozesszeit | 60 bis 120 min |

Mit oben beschriebenem Prozess konnten gut haftende und harte Schichten erzeugt werden. Vergleichtests der Schicht auf Dreh- und Frässwerkzeugen ergaben eine gegenüber bekannten TiAlN-Schichten deutlich verbesserte Standzeit obwohl die Rauigkeit deutlich über den Rauhwerten optimierter reiner TiAlN-Schichten lag.

Die in Tabelle 1 angeführten Versuche 2 bis 22 beziehen sich auf einfache erfindungsgemässe Schichtsysteme, die aus jeweils einer bei Beschichtungstemperaturen zwischen 450 und 600° hergestellten Doppeloxidschicht des $(Al_{1-x}Cr_x)_2O_3$-Typs bestehen. Die übrigen Parameter sind mit den oben beschriebenen Parametern zur Herstellung der Funktionsschicht identisch. Die Messung des stöchiometrischen Anteils der Schichtzusammensetzung erfolgte mittels Rutherford Backscattering Spectrometry (RBS). Die grösste Abweichung von der in Spalte 2 angeführten Legierungszusammensetzung des Targets zeigen die Versuche 10 bis 12 mit einer Abweichung von 3.5 Prozentpunkten bei einem Al/Cr-Verhältnis von 70/30. Die Metallanteile der Schicht werden dazu auf den Gesamtmetallgehalt des Oxids normiert. Demhingegen kommt es bezüglich der Stöchometrie des Sauerstoffs zu etwas grösseren Abweichungen bis über 8%. Trotzdem zeigen alle Schichten eine eindeutige korundartige Gitterstruktur. Bevorzugt sollten daher erfindungsgemässe Schichten eine Unterstöchiometrie bezüglich des Sauerstoffs von 0 bis 10% aufweisen, da auch noch bis in einem Bereich von ca. 15% Sauerstoffdefizit die gewünschte Gitterstruktur ausgebildet wird.

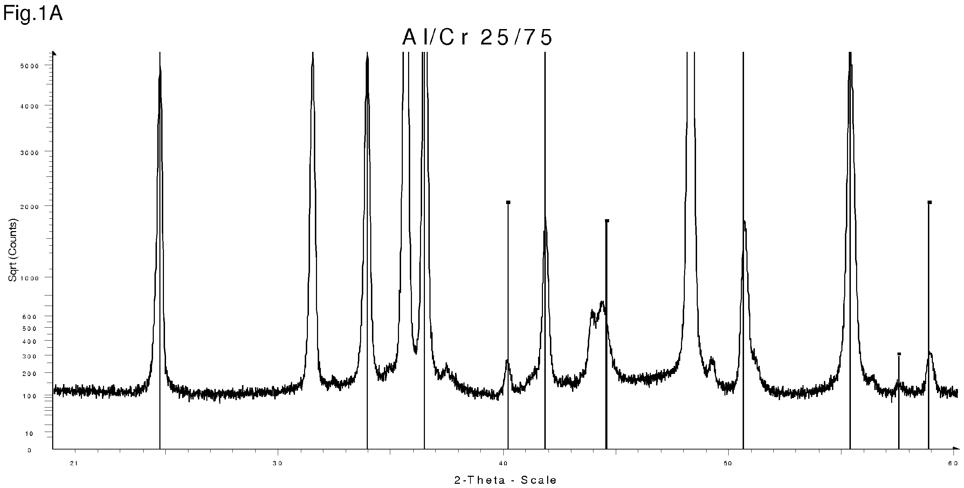

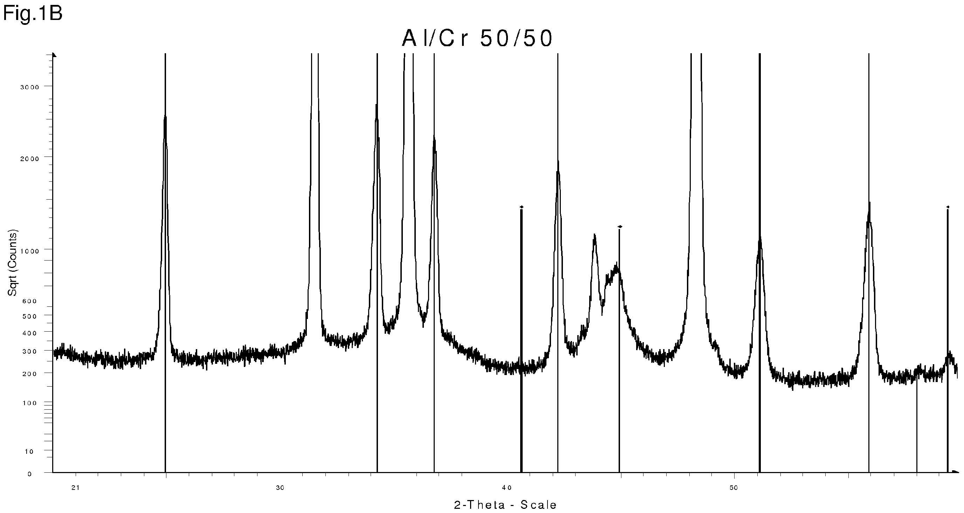

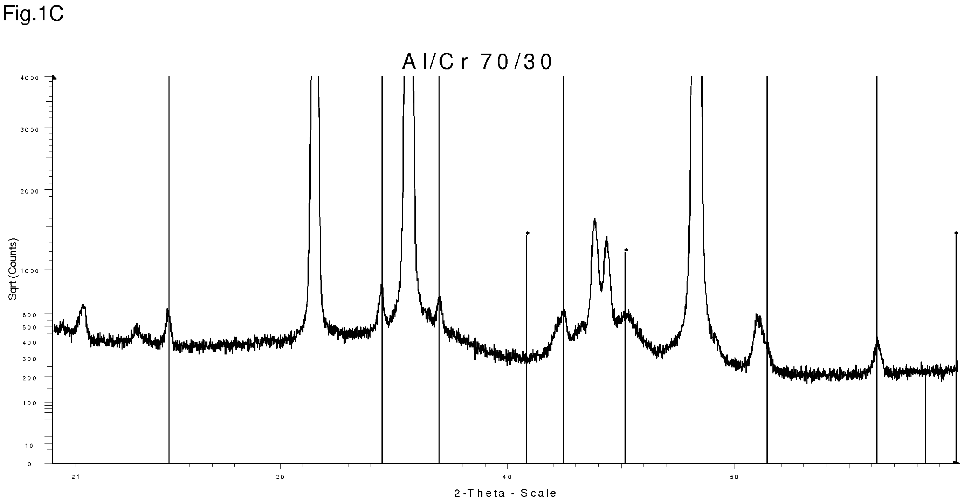

Fig.1 A bis C zeigen typische Korundstrukturen erfindungsgemässer $(Al_{1-x}Cr_x)_2O_3$-Schichten, die mit unterschiedlich legierten Targets gemäss Versuchen 18 (Al/Cr=25/75), 14 (50/50) und 3 (70/30) bei 550°C hergestellt wurden. Die Messungen und Auswertungen erfolgten mittels Röntgendiffraktometrie mit den oben unter Messmethoden näher beschriebenen Parametereinstellungen. Die Darstellung verzichtet auf eine Korrektur der Hintergrundsignale. Die Bestimmung der Gitterparameter kann auch mit anderen Methoden beispielsweise mit Elektronbeugungsspektrometrie erfolgen. Auf Grund der von Fig. 1A nach 1C von 3.1 auf 1.5 $\mu$m abnehmenden Schichtdicke wachsen die nicht markierten Substratlinien gegenüber den mit Strichen markierten Schichtlinien der Korundstruktur stark an. Trotzdem können auch in Spektrum C, trotz linearer Darstellung der Ordinatenachse, noch 7 Linien eindeutig dem Korundgitter zugeordnet werden. Die restlichen Linien sind dem Hartmetallgrundwerkstoff zuzuordnen (WC/Co-Legierung). Für eine eindeutige Zuordnung des Kristallgitters und der Bestimmung der Gitterkonstanten sollten allerdings zumindest 4 bis 5 Linien eindeutig identifizierbar sein.

Die Kristallstruktur der Schichten ist feinkristallin und grossteils mit einer mittleren Kristallitgrösse kleiner 0.2 $\mu$m, lediglich bei hohen Chromgehalten und Beschichtungstemperaturen von 650° wurden Kristallitgrössen zwischen 0.1 bis 0.2 $\mu$m gemessen.

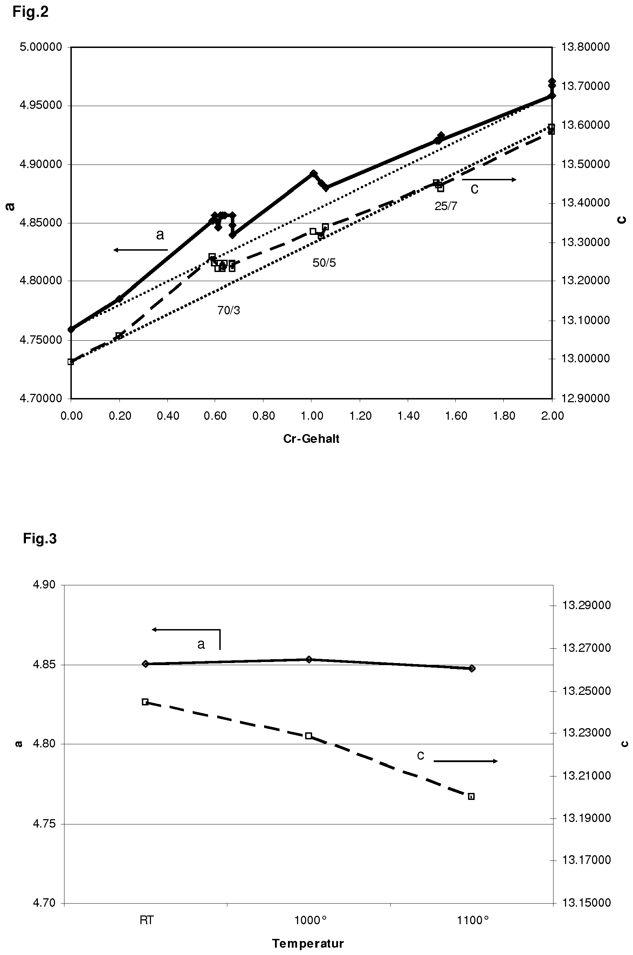

In Fig.2 werden für die Versuche 2 bis 22 die Gitterkonstanten a (durchgezogene Linie) und c (strichliert) des $(Al_{1-x}Cr_x)_2O_3$-Kristallgitters über dem stöchiometrischen Chromgehalt aufgetragen und mit den jeweils durch drei Werte DB1 bis 3 aus der ICDD (International Center for Diffraction Data) bestimmten punktierten Geraden nach dem Vegardschen Gesetz verglichen. Dabei zeigt sich über den gesamten Konzentrationsbereich eine maximale Abweichung von 0.7 bis 0.8 % von der idealen Vegardsgeraden. Auch Messungen an anderen Mehrfachoxidschichten zeigten ähnliche Ergebnisse, die Abweichungen liegen bei den angegebenen Parametern höchstens bei 1 %. Dies deutet auf sehr geringe Eigenspannungen der Mischkristallschicht hin, weshalb es im Gegensatz zu vielen anderen PVD-Schichten möglich ist die Schichten mit einer grösseren Schichtdicke, beispielsweise zwischen 10 und 30 $\mu$m, in Einzelfällen bis zu 40 $\mu$m mit guter Haftung abzuscheiden. Grössere Verspannungen in der Schicht konnten nur bei Anlegen hoher Substratspannungen (>150) und/oder Verwendung einer Ar/O2-Mischung des Prozessgasses mit hohem Ar-Anteil erzielt werden. Da für viele Anwendungen besonders Mehrfachschichtsysteme, wie unten näher beschrieben, gut geeinget sind, können bei Bedarf Schichtspannungen durch Auswahl einer bei Bedarf mehrlagigen, zwischen Werkstück und Mischkristallschicht vorgesehenen, Zwischenschicht und / oder einer Deckschicht in weitem Rahmen eingestellt werden. Beispielsweise können damit höhere Druckeigenspannungen zum Erhöhen der Schichthärte für Hartbearbeitungsprozesse eingestellt werden. Für industrielle Anwendungen mit hohem abrasivem Verschleiss können damit dicke Schichtsystemen mit Schichtdicken grösser 10 oder 20 $\mu$m wirtschaftlich hergestellt werden, wobei die Mischkristallschicht bevorzugt grösser 5 insbesondere grösser 8 $\mu$m gewählt wird.

Parallel dazu wurden Untersuchungen an 2 $\mu$m dicken Mischkristallschichten nach den oben beschriebenen Verfahren (Biegestreifenmethode nach Stoney und Biegescheibenmethode) durchgeführt. Dabei wurden Schichtspannung in einem Bereich zwischen spannungsfrei und kleinen Druck- oder Zugspannungen mit Werten kleiner oder gleich 0.5 GPa gemessen. Zum Abscheiden dicker PVD-Schichten sind jedoch auch noch Schichten mit etwas grösserer Schichtspannung von etwa 0.8 GPa geeignet. Eine weitere Möglichkeit besteht in einer Abfolge von abwechselnd mit Zug- bzw. mit Druckspannung abgeschiedenen dünnen Schichten ($\leq 1\mu$m) als Multilagensystem.

Zur Prüfung der Temperatur- und Oxidationsbeständigkeit der Korundstruktur der abgeschiedenen $(Al_{1-x}Cr_x)_2O_3$-Schichten wurden gemäss Tabelle 2, Versuch 2, beschichtete Hartmetallprüfkörper mit erhöhtem Co-Gehalt innerhalb 50 Minuten auf eine Temperatur von 1000° bzw. 1100° C aufgeheizt dort 30 Minuten gehalten und anschliessend innerhalb 50 Minuten auf 300° C abgekühlt. Nach Abkühlen auf Raumtemperatur wurden die Gitterkonstanten neu bestimmt. Gemäss dem in den "Phase Equilibria Diagrams Volume XII Oxides" der American Ceramic Society angegebenen Phasendiagrams [W.Sitte, Mater.Sci.Monogr., 28A, React. Solids 451-456, 1985] ist im Bereich zwischen ca. 5 bis 70% Aluminium d.h. $(Al_{0.05-0.7}Cr_{x0.95-0.30})_2O_3$ für Temperaturen bis ca. 1150° C eine Mischungslücke angegebenen, die eine Entmischung des $(Al_{1-x}Cr_x)_2O_3$ Mischkristall in $Al_2O_3$ bzw. $Cr_2O_3$ und einen $(Al_{1-x}Cr_x)_2O_3$ Mischkristall einer anderen Zusammensetzung erwarten lässt. An Hand des Diagrams ist auch erkennbar, dass es durch den erfindungsgemässen Prozess gelingt die thermodynamisch Bildungstemperatur für $(Al_{1-x}Cr_x)_2O_3$ Mischkristallschichten von 1200° C auf 450° bis 600°C zu verschieben. Überraschenderweise zeigt sich aber auch, dass die erfindungsgemäss hergestellten Mischkristallschichten durch den Glühprozess nur minimale Änderungen in den Gitterkonstanten aufweisen und auch keine Entmischung in die binären Komponenten auftritt. Die maximale aus Fig.3 ersichtliche Abweichung von der nach dem Beschichtungsprozess bei Raumtemperatur gemessenen Wert der Gitterparameter a und der geglühten Probe liegt bei ca. 0.064%, die maximale Abweichung des Wertes c bei 0.34%. Auch für verschiedene andere Mehrfachoxide zeigte sich bei Messungen eine ausserordentliche Temperaturstabilität der Schicht und ein geringes Abweichen der Gitterkonstanten von höchstens 1 bis 2 %.

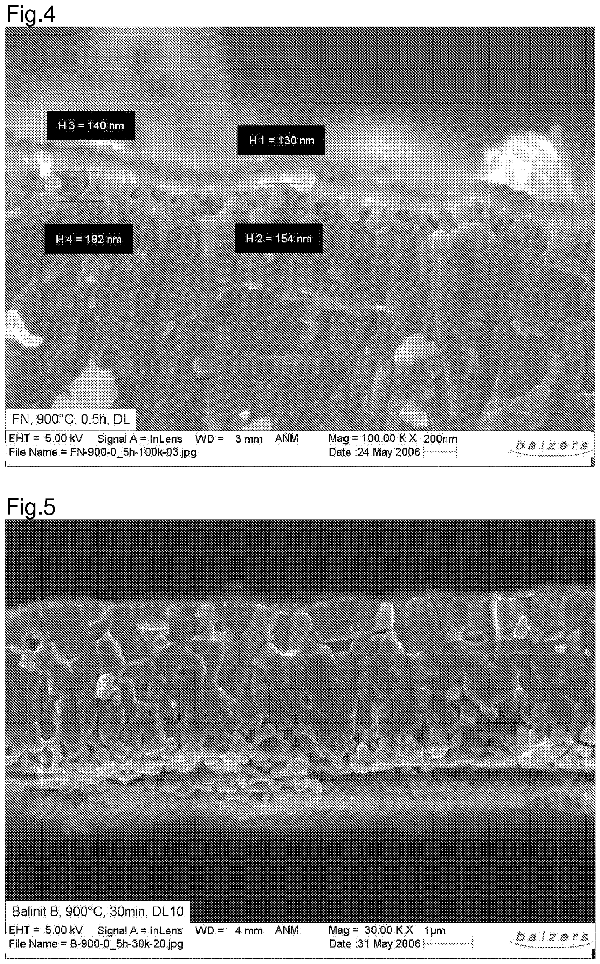

Fig.4 und Fig.5 zeigen die Ergebnisse von Oxidationsversuchen bekannter Schichtsysteme an Hand eines REM-Bruchbilds einer TiAlN- bzw. einer TiCN-Schicht, die wie oben beschrieben auf 900° C aufgeheizt und anschliessend 30 Minuten bei dieser Temperatur unter Sauerstoff geglüht wurde. An der TiAlN-Schicht ist in einem Bereich von über 200 nm eine deutliche Veränderung der Oberflächenstruktur zu erkennen. Einer im wesentlichen aus Aluminiumoxid bestehenden äusseren Schicht mit Schichdicke zwischen 130 und 140 nm folgt eine poröse aluminiumverarmte Schicht mit Schichdicke zwischen 154 und 182 nm. Noch wesentlich schlechter ist das Oxidationsverhalten der TiCN-Schicht in Fig.5, die bei einer solchen Behandlung bis auf den Grundwerkstoff durchoxidiert wird und eine beginnende Schichtablösung im rechten Bereich des Bildes zeigt. Die Schicht ist grobkörnig und zeigt nicht mehr die kolumnare Struktur der ursprünglichen TiCN-Schicht.

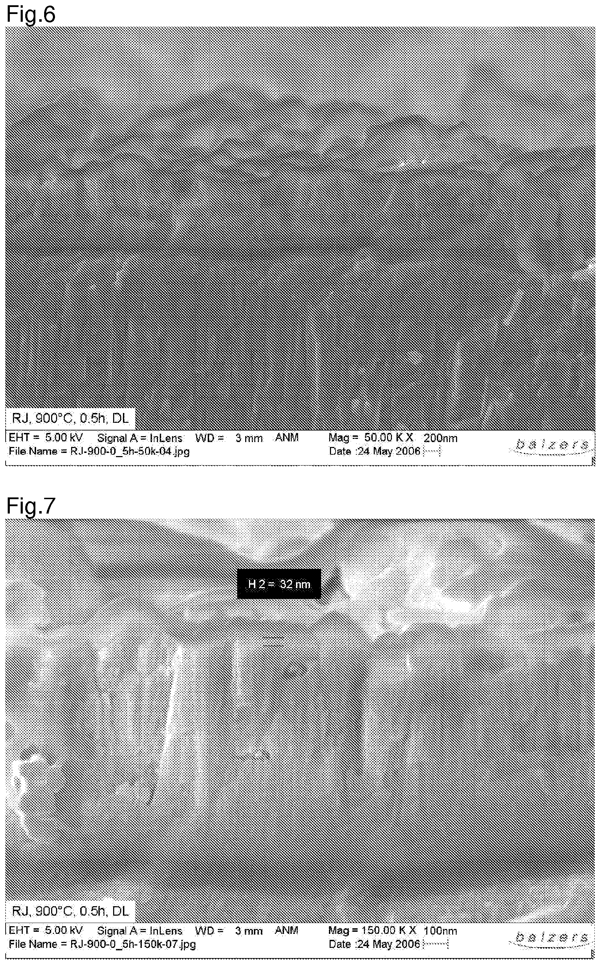

Fig.6 und Fig.7 zeigen die Ergebnisse identischer Oxidationsversuche an einer TiCN-Schicht, die durch eine ca. 1 $\mu$m dicke erfindungsgemässe $(Al_{0.7}Cr_{0.3})_2O_3$-Schicht geschützt ist. Fig.6 zeigt den Schichtverbund in 50.000-facher Vergrösserung. Die bekannte kolumnare Struktur der TiCN-Schicht und die etwas feiner kristallin aufgewachsene $(Al_{0.7}Cr_{0.3})_2O_3$-Schicht sind deutlich erkennbar. Die Kristallitgrösse der Aluminiumchromoxidschicht kann dabei beispielsweise durch Verwendung von Targets mit einem höheren Al-Gehalt noch verfeinert werden. Fig.7 zeigt den Schichtverbund in 150.000-facher Vergrösserung, die TiCN-Schicht ist nur noch am unteren Bildrand zu ekennen. Gegenüber den Schichten in Fig.4 und Fig.5 ist die Reaktionszone der $(Al_{0.5}Cr_{0.5})_2O_3$-Schicht mit einer Dicke H2 von maximal 32nm wesentlich schmäler und weist eine dichte Struktur ohne erkennbare Poren auf. Bei einer Serie vergleichender Versuche mit unterschiedlichen erfindungsgemässen Mischkristallschichten zeigte sich, dass diese, im Gegensatz zu anderen Oxidschichten aus dem Stand der Technik, die darunterliegenden Zwischenschichten schützen und somit dem gesamten Schichtsystem eine ausgezeichnete thermische und oxidative Beständigkeit verleihen. Grundsätzlich können zu diesem Zweck alle erfindungsgemässen Mischkristallschichten eingesetzt werden, die in oben beschriebenen Oxidationstest keine Reaktionszonen ausbilden, die 100 nm übersteigen. Bevorzugt sind Mischkristallschichten mit Reaktionszonen zwischen 0 bis 50 nm.

Die gemessenen Schichthärten der $(Al_{0.5}Cr_{0.5})_2O_3$-Schichten liegen bei ca. 2000 $HV_{50}$. Auch durch Messungen an anderen Mehrfachoxiden, wie beispielsweise die $(Al_{0.5}Ti_{0.3}Cr_{0.2})_2O_3$, oder $(Al_{0.6}Ti_{0.4})_2O_3$, $(V_{0.5}Cr_{0.5})_2O_3$, $(Al_{0.2}Cr_{0.8})_2O_3$, konnten Werte zwischen 1200 und 2500 HV ermittelt werden.

In Tabelle 3.bis 6. sind weitere mehrlagige Ausführungen des erfindungsgemässen Schichtsystems aufgeführt. Prozessparameter zur Herstellung für AlCrO- bzw. AlCrON-Mischkristallschichten auf einem 4 Quellenbeschichtungssystem (RCS) finden sich in Tabelle 7, entsprechende Prozessparameter zur Herstellung einzelner Schichtlagen für diverse Stüzschichten in Tabelle 8.

Die Versuche 23 bis 60 in Tabelle 3 und 4 beziehen sich dabei auf Schichtsysteme in denen die oxidischen Mischkristallschicht durchgehend in Korundstruktur, meist als Einzelschicht aufgebaut ist. Lediglich in Versuch 25, 29 und 31 ist die Mischkristallschicht aus zwei aufeinanderfolgenden Einzellagen unterschiedlicher chemischer Zusammensetzung aufgebaut. In Versuch 29 unterscheiden sich die Mischkristallschichten lediglich durch ein unterschiedliches Al/Cr-Verhältnis.

Die Versuche 61 bis 107 in Tabelle 5 und 7 beziehen sich dabei auf Schichtsysteme in denen die Mischkristallschicht aus 5 bis 100 Lagen einzelner sehr dünner Schichten zwischen 50 nm und 1 $\mu$m aufgebaut ist. Dabei können sich sowohl oxidische Mischkristallschichten in Korundstruktur mit unterschiedlicher chemischer Zusammensetzung, als auch entsprechende Mischkristallschichten mit anderen Schichtsystemen abwechseln.

Vergleichende Versuche mit unterschiedlichen Dreh- und Frästests ergaben für Schichten der Versuche 23, 24 und 61 bis 82 im Drehen als auch im Fräsen deutliche Verbesserungen gegenüber bekannten Schichtsystemen wie TiAlN, TiN/TiAlN und AlCrN. Auch im Vergleich mit CVD-Schichten konnten sowohl beim Fräsen wie auch für einige Anwendungen im Drehen verbesserte Standzeiten der Werkzeuge erzielt werden.

Wiewohl, wie oben angegeben, bereits eine ganze Reihe unterschiedlicher Schichtsysteme untersucht und getestet wurden, wird der Fachmann bei Bedarf auf bekannte Massnahmen zurückgreifen, falls er bestimmte Eigenschaften des erfindungsgemässen Schichtsystems an spezielle Anforderungen anpassen will. Beispielsweise kann der Einbau von weiteren Elemente in einzelnen oder auch allen Schichten des Systems, insbesondere aber in die Mischkristallschicht in Erwägung gezogen werden. Bekannte Elemente, die beispielsweise zumindest bei nitridischen Schichten die Hochtemperaturbeständigkeit günstig beeinflussen sind Zr, Y, La oder Ce.

Tabelle 1

| V.Nr. | Target [Al/Cr] | Abscheidetemperatur [°C] | Glühtemperatur [°C] | Stöchiometr. Anteil | | | Cr/ (Cr+Al) | Gitterkonstanten | | | d [um] |
|---|---|---|---|---|---|---|---|---|---|---|---|
| | | | | Cr | Al | O | | a | C | c/a | |
| DB1- | Al$_2$O$_3$ | | | 0.00 | 2.00 | 3.00 | 0.00 | 4.75870 | 12.99290 | 2.7303 | |
| DB2 - | 90/10 | | | 0.20 | 1.80 | 3.00 | 0.10 | 4.78550 | 13.05900 | 2.7289 | |
| 2 | 70/30 | 550° | - | 0.59 | 1.41 | 3 | 0.30 | 4.85234 | 13.26296 | 2.7333 | 1.5 |
| 3 | 70/30 | 550° | - | 0.60 | 1.40 | 2.80 | 0.30 | 4.85610 | 13.24587 | 2.7277 | 3.3 |
| 4 | 70/30 | 600° | - | 0.61 | 1.39 | 3.00 | 0.31 | 4.84603 | 13.23092 | 2.7303 | 3.3 |
| 5 | 70/30 | 550° | - | 0.62 | 1.38 | 2.75 | 0.31 | 4.85610 | 13.24587 | 2.7277 | 3.1 |
| 6 | 70/30 | 550° | - | 0.64 | 1.36 | 3.1 | 0.32 | 4.85610 | 13.24587 | 2.7277 | 2.9 |
| 7 | 70/30 | 550° | - | 0.63 | 1.37 | 2.90 | 0.32 | 4.85612 | 13.23089 | 2.7246 | 2.7 |
| 8 | 70/30 | 550° | - | 0.67 | 1.33 | 2.8 | 0.34 | 4.88443 | 13.15461 | 2.6932 | |
| 9 | 70/30 | 550° | - | 0.68 | 1.32 | 2.95 | 0.34 | 4.86815 | 13.15461 | 2.7022 | 1.9 |
| 10 | 70/30 | 550° | - | 0.67 | 1.33 | 3 | 0.34 | 4.85610 | 13.24587 | 2.7277 | 1.9 |
| 11 | 70/30 | 550° | - | 0.67 | 1.33 | 2.95 | 0.34 | 4.84804 | 13.23103 | 2.7292 | 2.5 |
| 12 | 70/30 | 550° | - | 0.67 | 1.33 | 2.85 | 0.34 | 4.83993 | 13.24192 | 2.7360 | 2.5 |
| 13 | 50/50 | 500° | - | 1.01 | 0.99 | 2.80 | 0.51 | 4.89218 | 13.32858 | 2.7245 | 1.9 |
| 14 | 50/50 | 550° | - | 1.04 | 0.96 | 2.95 | 0.52 | 4.88403 | 13.31746 | 2.7267 | 3.5 |
| 15 | 50/50 | 600° | - | 1.06 | 0.94 | 2.95 | 0.53 | 4.87996 | 13.33965 | 2.7336 | |
| 16 | 25/75 | 600° | - | 1.52 | 0.48 | 2.85 | 0.76 | 4.92028 | 13.44988 | 2.7336 | 4.5 |
| 17 | 25/75 | 500° | - | 1.54 | 0.46 | 2.8 | 0.77 | 4.92464 | 13.43581 | 2.7283 | 4.5 |
| 18 | 25/75 | 550° | - | 1.53 | 0.47 | 2.8 | 0.77 | 4.92053 | 13.44655 | 2.7327 | |
| 19 | 0/100 | 550° | - | 2.00 | 0.00 | 2.80 | 1.00 | 4.95876 | 13.58287 | 2.7392 | 2.0 |
| 21 | 0/100 | 450° | - | 2.00 | 0.00 | 2.85 | 1.00 | 4.97116 | 13.58280 | 2.7323 | 2.0 |
| 22 | 0/100 | 500° | - | 2.00 | 0.00 | 2.75 | 1.00 | 4.97116 | 13.59412 | 2.7346 | |
| DB3 - | Cr$_2$O$_3$ | | | 2.00 | 0.00 | 3.00 | 1.00 | 4.95876 | 13.59420 | 2.7415 | |

Tabelle 2

| V.Nr. | Target [Al/Cr] | Abscheidetemperatur [°C] | Glühtemperatur [°C] | | | | | Gitterkonstanten | | |
|---|---|---|---|---|---|---|---|---|---|---|
| | | | | | | | | a | c | c/a |
| 2 | 70/30 | 550° | RT | - | - | - | - | 4.85030 | 13.24484 | 2.7307 |
| 2 | 70/30 | 550° | 1000° | - | - | - | - | 4.85339 | 13.22837 | 2.7256 |
| 2 | 70/30 | 550° | 1100° | - | - | - | - | 4.84727 | 13.20028 | 2.7232 |
| Testkörper: Hartmetall | | | | | | | | | | |

Tabelle 3

| VNr. | Zwischenschicht | | | | Mischkristallschicht Monolayer | | | | Deckschicht | | | |
| | Haftschicht | | Hartschicht | | Korundstruktur | | Weit. Oxidschicht | | DS1 | | DS2 | |
| | [(Me1Me2)X] | d [um] | [(Me1Me2)X] | d [um] | [(Me1 Me2)X] | d [um] | [(Me1 Me2)X] | d [um] | [(Me1 Me2)X] | d [um] | [(Me1 Me2)X] | d [um] |
|---|---|---|---|---|---|---|---|---|---|---|---|---|
| 23 | TiN | 0.2 | TiAlN | 3.0 | $(Al_{.5}Cr_{.5})_2O_3$ | 3.0 | wo | | wo | | wo | |
| 24 | wo | | TiAlN | 3.0 | $(Al_{.5}Cr_{.5})_2O_3$ | 3.0 | wo | | wo | | wo | |
| 25 | TiN | 0.3 | TiAlN | 4.0 | $(Al_{.5}Cr_{.5})_2O_3$ | 2.0 | $(Al_{.7}Cr_{.3})_2O_3$ | 1.0 | | | | |
| 26 | TiN | 0.4 | TiCN | 6.0 | $(Al_{.65}Cr_{.35})_2O_3$ | 5.0 | | | | | | |
| 27 | TiN | 8.0 | | | $(Al_{.65}Cr_{.35})_2O_3$ | 8.0 | | | | | | |
| 28 | | | TiCN | 8.0 | $(Al_{.7}Cr_{.3})_2O_3$ | 6.0 | | | | | | |
| 29 | TiN | 0.5 | TiAlN | 3.0 | $(Al_{.7}Cr_{.3})_2O_3$ | 3.0 | $(Al,Cr,Zr)_2O_{3+x}$ | | $ZrO_2$ | 1.0 | ZrN | 0.5 |
| 30 | TiN | 0.3 | TiC | 4.0 | $(Al_{.7}Cr_{.3})_2O_3$ | 2.0 | | | | | | |
| 31 | TiN | 0.4 | TiAlN | 2.0 | $(Al_{.7}Fe_{.3})_2O_3$ | 4.0 | $(Al,Cr)_2O_3$ | 2.0 | AlCrN | 0.5 | | |
| 32 | TiN | | | | $(Al_{.6}Fe_{.4})_2O_3$ | 5.0 | | | AlCrN | 2.0 | | |
| 33 | TiN | | TiCN | 8.0 | $(Al_{.6}Fe_{.4})_2O_3$ | 4.0 | | | | | | |
| 34 | | | TiCN | 8.0 | $(Al_{.1}Fe_{.9})_2O_3$ | 4.0 | | | | | | |
| 35 | wo | | TiAlN | 3.0 | $(Al_{.1}Fe_{.9})_2O_3$ | 5.0 | | | | | | |
| 36 | wo | | wo | | $(Al_{.5}Fe_{.5})_2O_3$ | 8.0 | | | | | | |
| 37 | wo | | wo | | $(Al_{.5}Fe_{.5})_2O_3$ | 8.0 | | | AlCrN | 3.0 | | |
| 38 | TiN | 0.3 | wo | | $(Al_{.5}V_{.5})_2O_3$ | 5.0 | | | | | TiN | 0.3 |
| 39 | VN | 0.4 | VCN | 4.0 | $(Al_{.5}V_{.5})_2O_3$ | 6.0 | | | AlVN | 1.0 | | |
| 40 | VN | 0.4 | | | $(Al_{.5}V_{.5})_2O_3$ | 10.0 | | | AlVN | 1.0 | | |
| 41 | CrN | 0.5 | CrC | 4.0 | $Cr_2O_3$ | 3.0 | | | CrN | 2.0 | | |
| 42 | CrN | 0.5 | CrCN | 6.0 | $Cr_2O_3$ | 4.0 | | | CrN | 1.0 | | |
| 43 | CrN | 0.5 | wo | | $Cr_2O_3$ | 4.0 | | | CrN | 2.0 | | |
| 44 | CrN | 0.5 | wo | | $Cr_2O_3$ | 5.0 | | | | | | |
| 45 | AlCrN | 0.3 | wo | | $(Al_{.2}Cr_{.8})_2O_3$ | 4.0 | | | AlCrN | 1.0 | | |

Tabelle 4

| VNr. | Zwischenschicht | | | | Mischkristallschicht Monolayer | | | | Deckschicht | | | |
| | Haftschicht | | Hartschicht | | Korundstruktur | | Weit. Oxidschicht | | DS1 | | DS2 | |
| | [(Me1Me2)X] | d [um] | [(Me1Me2)X] | d [um] | [(Me1Me2)X] | d [um] | [(Me1Me2)X] | d [um] | [(Me1Me2)X] | d [um] | [(Me1Me2)X] | d [um] |
|---|---|---|---|---|---|---|---|---|---|---|---|---|
| 46 | CrN | 0,3 | AlCrON | 5.0 | $(Al_{.02}Cr_{.98})_2O_3$ | 3.0 | | | | | | |
| 47 | CrN | 0,5 | AlCrN | 3.0 | $(Al_{.05}Cr_{.95})_2O_3$ | 3.0 | | | $(Al_{.7}Cr_{.3})_2O_3$ | 1.0 | CrN | 2.0 |
| 48 | AlCrN | 0,5 | AlCrON | 5.0 | $(Al_{.05}Cr_{.95})_2O_3$ | 3.0 | | | | | | |
| 49 | TiN | 0.8 | TiAlN | 4.0 | $(Al_{.5}Ti_{.5})_2O_3$ | 4.0 | | | TiN | 1.0 | | |
| 50 | wo | | TiAlN | 6.0 | $(Al_{.5}Ti_{.5})_2O_3$ | 2.0 | | | | | | |
| 51 | TiN | 0.3 | TiCN | 8.0 | $(Al_{.7}Ti_{.3})_2O_3$ | 4.0 | | | | | | |
| 52 | wo | | TiAlN | 3.0 | $(Al,Mg,Ti)_2O_3$ | 3.0 | | | | | | |
| 53 | TiN | 0.5 | AlMgTiN | 6.0 | $(Al,Mg,Ti)_2O_3$ | 4.0 | | | | | | |
| 54 | TiN | 5.0 | | | $(Al,Mg,Ti)_2O_3$ | 3.0 | | | TiN | 2.0 | | |
| 55 | TiN | 0.3 | (Al,Mg,Ti)ON | 5.0 | $(Al,Mg,Ti)_2O_3$ | 2.0 | | | | | | |
| 56 | AlCrN | 0.2 | (Al,Mg,Ti)ON | 1.0 | $(Al,Mg,Ti)_2O_3$ | 6.0 | | | | | | |
| 57 | TiN | 1.0 | | | $(Al,Fe,Ti)_2O_3$ | 5.0 | | | TiN | 0.5 | | |
| 58 | TiN | 1.0 | TiCN | 6.0 | $(Al,Fe,Ti)_2O_3$ | 2.0 | | | TiN | 1.0 | | |
| 59 | TiN | 1.0 | TiAlN | 4.0 | $(Al,Fe,Ti)_2O_3$ | 4.0 | | | | | | |
| 60 | | | TiCN | 4.0 | $(Al,Fe,Ti)_2O_3$ | 2.0 | | | | | | |

EP 2 082 079 B1

Tabelle 5.

| VNr. | Zwischenschicht | | | | Mischkristallschicht als Multilayer | | | | Deckschicht | | | | | |
| | Haftschicht | | Hartschicht | | Korundstruktur | | Weit. ML-Schicht | | No.MLs | DS1 | | | DS2 | |
| | [(Me1 Me2)X] | d [um] | [(Me1 Me2)X] | d [um] | [(Me1 Me2)X] | d [um] | [(Me1 Me2)X] | d [um] | | [(Me1Me2)X] | d [um] | [(Me1 Me2)X] | d [um] |
|---|---|---|---|---|---|---|---|---|---|---|---|---|---|
| 61 | TiN | 0.2 | TiAlN | 3.0 | $(Al_{.65}Cr_{.35})_2O_3$ | 0.100 | AlCrN | 0.100 | 50.0 | AlCrN | 0.5 | | |
| 62 | wo | | TiAlN | 2.0 | $(Al_{.65}Cr_{.35})_2O_3$ | 0.500 | AlCrN | 0.500 | 10.0 | | | | |
| 63 | TiN | 0.3 | TiAlN | 3.0 | $(Al_{.65}Cr_{.35})_2O_3$ | 0.100 | AlCrN | 0.050 | 100.0 | AlCrN | 0.2 | | |
| 64 | TiN | 0.3 | TiAlN | 4.0 | $(Al_{.65}Cr_{.35})_2O_3$ | 0.050 | AlCrN | 0.050 | 100.0 | | | | |
| 65 | TiN | 0.3 | TiAlN | 3.0 | $(Al_{.65}Cr_{.35})_2O_3$ | 0.100 | $ZrO_2$ | 0.300 | 10.0 | ZrN | 1.0 | | |
| 66 | TiN | 0.3 | TiAlN | 6.0 | $(Al_{.65}Cr_{.35})_2O_3$ | 0.200 | $Ta_2O_5$ | 0.100 | 30.0 | TaN | 0.5 | | |
| 67 | TiN | 0.3 | TiAlN | 3.0 | $(Al_{.65}Cr_{.35})_2O_3$ | 0.200 | $Nb_2O_5$ | 0.500 | 10.0 | NbN | 1.0 | | |
| 68 | TiN | 0.3 | TiAlN | 4.0 | $(Al_{.65}Cr_{.35})_2O_3$ | 0.200 | $V_2O_3$ | 0.100 | 50.0 | | | | |
| 69 | TiN | 0.3 | TiAlN | 3.0 | $(Al_{.65}Cr_{.35})_2O_3$ | 0.200 | $(Al_{.8}Cr_{.2})_2O_3$ | 0.050 | 30.0 | AlCrN | 0.2 | | |
| 70 | TiN | 0.3 | TiAlN | 2.0 | $(Al_{.65}Cr_{.35})_2O_3$ | 0.200 | $(Al,V)_2O_3$ | 0.050 | 30.0 | AlVN | 0.2 | | |
| 71 | TiN | 0.3 | TiAlN | 2.0 | $(Al_{.5}Cr_{.5})_2O_3$ | 0.100 | TiAlN | 0.100 | 50.0 | | | | |
| 72 | TiN | 0.2 | TiCN | 6.0 | $(Al_{.5}Cr_{.5})_2O_3$ | 0.100 | 0.100 | 0.100 | 50.0 | AlCrN | 0.5 | | |
| 73 | wo | | TiCN | 3.0 | $(Al_{.5}Cr_{.5})_2O_3$ | 0.500 | AlCrN | 0.500 | 10.0 | | | | |
| 74 | TiN | 0.3 | TiCN | 12.0 | $(Al_{.5}Cr_{.5})_2O_3$ | 0.100 | AlCrN | 0.050 | 100.0 | AlCrN | 0.2 | | |
| 75 | TiN | 0.3 | TiCN | 8.0 | $(Al_{.5}Cr_{.5})_2O_3$ | 0.050 | AlCrN | 0.050 | 100.0 | | | | |
| 76 | TiN | 0.3 | TiCN | 4.0 | $(Al_{.5}Cr_{.5})_2O_3$ | 0.100 | $ZrO_2$ | 0.300 | 10.0 | ZrN | 1.0 | | |
| 77 | TiN | 0.3 | TiCN | 3.0 | $(Al_{.5}Cr_{.5})_2O_3$ | 0.200 | $Ta_2O_5$ | 0.100 | 30.0 | TaN | 0.5 | | |
| 78 | TiN | 0.3 | TiCN | 6.0 | $(Al_{.4}Cr_{.6})_2O_3$ | 0.200 | $Nb_2O_5$ | 0.500 | 10.0 | NbN | 1.0 | | |
| 79 | TiN | 0.3 | TiCN | 3.0 | $(Al_{.4}Cr_{.6})_2O_3$ | 0.200 | $V_2O_3$ | 0.100 | 50.0 | | | | |
| 80 | TiN | 0.3 | TiCN | 2.0 | $(Al_{.4}Cr_{.6})_2O_3$ | 0.200 | $(Al,Cr)_2O_3$ | 0.050 | 30.0 | AlCrN | 0.2 | | |
| 81 | TiN | 0.3 | TiCN | 3.0 | $(Al_{.4}Cr_{.6})_2O_3$ | 0.200 | $(Al,Zr)_2O_3$ | 0.050 | 30.0 | AlZrN | 0.2 | | |
| 82 | TiN | 0.3 | TiC | 4.0 | $(Al_{.4}Cr_{.6})_2O_3$ | 0.100 | AlCrN | 0.050 | 100.0 | TiN | 0.2 | | |
| 83 | TiN | 0.5 | TiAlN | 3.0 | $(Al_{.4}Cr_{.6})_2O_3$ | 0.300 | $(Al,Cr,Zr)_2O_{3+x}$ | 0.300 | | ZrN | 1.0 | ZrN | 0.5 |

(fortgesetzt)

| VNr. | Zwischenschicht | | | | Mischkristallschicht als Multilayer | | | | Deckschicht | | | | | |
| | Haftschicht | | Hartschicht | | Korundstruktur | | Weit. ML-Schicht | | No.MLs | DS1 | | | DS2 | |
| | [(Me1 Me2)X] | d [um] | [(Me1 Me2)X] | d [um] | [(Me1 Me2)X] | d [um] | [(Me1 Me2)X] | d [um] | | [(Me1Me2)X] | d [um] | | [(Me1 Me2)X] | d [um] |
| 84 | TiN | 0.4 | TiAlN | 2.0 | $(Al_{.7}Cr_{.3})_2O_3$ | 0.200 | $(Al,Cr)_2O_3$ | 0.200 | 10.0 | AlCrN | 0.5 | | | |
| 85 | TiN | 0.3 | wo | | $(Al_{.6}V_{.4})_2O_3$ | 0.200 | AlVN | 0.100 | | | | | TiN | 0.3 |
| 86 | VN | 0.4 | VCN | 4.0 | $(Al_{.6}V_{.4})_2O_3$ | 0.200 | $(Al,Cr)_2O_3$ | 0.100 | | | | | | |

Tabelle 6

| VNr. | Zwischenschicht Haftschicht [(Me1 Me2)X] | d [um] | Hartschicht [(Me1 Me2)X] | d [um] | Mischkristallschicht als Multilayer Korundstruktur [(Me1 Me2)X] | d [um] | Weit. ML-Schicht [(Me1 Me2)X] | d [um] | Deckschicht No.MLs | DS1 [(Me1 Me2)X] | d [um] | DS2 [(Me1 Me2)X] | d [um] |
|---|---|---|---|---|---|---|---|---|---|---|---|---|---|
| 87 | CrN | 0.5 | CrC | 4.0 | $Cr_2O_3$ | 0.200 | CrN | 0.300 | 5.0 | CrN | 2.0 | | |
| 88 | CrN | 0.5 | CrCN | 6.0 | $Cr_2O_3$ | 0.200 | $(Al_{.65}Cr_{.35})_2O_3$ | 0.100 | 10.0 | CrN | 1.0 | | |
| 89 | CrN | 0.5 | wo | | $Cr_2O_3$ | 1.000 | $(Al_{.65}Cr_{.35})_2O_3$ | 0.500 | 5.0 | | | | |
| 90 | CrN | 0.5 | wo | | $Cr_2O_3$ | 0.050 | $(Al_{.65}Cr_{.35})_2O_3$ | 0.050 | 200.0 | | | | |
| 91 | CrN | 0.5 | wo | | $Cr_2O_3$ | 0.050 | CrN | 0.050 | 100.0 | | | | |
| 92 | AlCrN | 0.3 | wo | | $(Al_{.65}Cr_{.35})_2O_3$ | 0.100 | CrN | 0.400 | 8.0 | AlCrN | 1.0 | | |
| 93 | CrN | 0,3 | AlCrON | 5.0 | $(Al_{.5}Cr_{.5})_2O_3$ | 0.200 | $(Al_{.7}Cr_{.3})_2O_3$ | 0.100 | 10.0 | | | | |
| 94 | CrN | 0,5 | AlCrN | 3.0 | $(Al_{.5}Cr_{.5})_2O_3$ | 1.000 | $(Al_{.7}Cr_{.3})_2O_3$ | 0.500 | 5.0 | CrN | 0.5 | CrN | 2.0 |
| 95 | AlCrN | 0,5 | AlCrON | 5.0 | $(Al_{.5}Cr_{.5})_2O_3$ | 0.050 | $(Al_{.7}Cr_{.3})_2O_3$ | 0.050 | 200.0 | | | | |
| 96 | TiN | 0.8 | TiAlN | 4.0 | $(Al_{.5}Ti_{.5})_2O_3$ | 0.100 | TiAlN | 0.200 | 30.0 | TiN | 1.0 | | |
| 97 | wo | | TiAlN | 6.0 | $(Al_{.1}Ti_{.9})_2O_3$ | 0.050 | TiAlN | 0.300 | 10.0 | | | | |
| 98 | TiN | 0.3 | TiCN | 8.0 | $(Al_{.1}Ti_{.9})_2O_3$ | 0.200 | $(Al_{.7}Cr_{.3})_2O_3$ | 0.100 | 20.0 | | | | |
| 99 | wo | | TiAlN | 3.0 | $(Al,Mg,Ti)_2O_3$ | 0.100 | 0.100 | 0.100 | 40.0 | | | | |
| 100 | TiN | 0.5 | AlMgTiN | 6.0 | $(Al,Mg,Ti)_2O_3$ | 0.500 | AlCrN | 0.500 | 12.0 | | | | |
| 101 | TiN | 5.0 | | | $(Al,Mg,Ti)_2O_3$ | 0.100 | AlCrN | 0.050 | 50.0 | | | | |
| 102 | TiN | 0.3 | (Al,Mg,Ti)ON | 5.0 | $(Al,Mg,Ti)_2O_3$ | 0.050 | AlCrN | 0.050 | 30.0 | | | | |
| 103 | AlCrN | 0.2 | (Al,Mg,Ti)ON | 1.0 | $(Al,Mg,Ti)_2O_3$ | 0.100 | $(Al_{.65}Cr_{.35})_2O_3$ | 0.300 | 15.0 | | | | |
| 104 | TiN | 1.0 | | | $(Al,Fe,Ti)_2O_3$ | 0.200 | $Nb_2O_5$ | 0.500 | 20.0 | TiN | 0.5 | | |
| 105 | TiN | 1.0 | TiCN | 6.0 | $(Al,Fe,Ti)_2O_3$ | 0.200 | $V_2O_3$ | 0.100 | 20.0 | TiN | 1.0 | | |
| 106 | TiN | 1.0 | TiAlN | 4.0 | $(Al,Fe,Ti)_2O_3$ | 0.200 | $(Al_{.65}Cr_{.35})_2O_3$ | 0.100 | 10.0 | | | | |
| 107 | | | TiCN | 4.0 | $(Al,Fe,Ti)_2O_3$ | 0.200 | $(Al,Me)_2O_3$ | 0.050 | 15.0 | | | | |

Tabelle 7

| Material | I-Source 1 | I-S.2 | I-S.3 | I-S.4 | U-Bias-bp | O2 | N2 | p | T |
|---|---|---|---|---|---|---|---|---|---|
| | [A] | [A] | [A] | [A] | [V] | [sccm] | [sccm] | [Pa] | [°C] |
| AlCrO | -- | 200 | -- | 200 | -60 | 1000 | -- | 2.6 | 550° C |
| AlCrO-AlCrN Multilaye r | -- | 200 | -- | 200 | -60 | 1000 | 1000 | 2.6 | 550° C |

Spulenstrom des Quellenmagnetsystems 0.5 bis 1 A

Tabelle 8

| Material | I-Source 1 | I-S.2 | I-S.3 | I-S.4 | U-Bias DC | Ar | C2H2 | N2 | p | T |
|---|---|---|---|---|---|---|---|---|---|---|
| | [A] | [A] | [A] | [A] | [V] | [sccm] | [sccm] | [sccm] | [Pa] | [°C] |
| TiAlN | 200 | -- | 200 | -- | -40 | | -- | druckgeregelt | 3 | 550° C |
| TiN | 180 | -- | 180 | -- | -100 | | -- | druckgeregelt | 0.8 | 550° C |
| TiCN | 190 | -- | 190 | -- | -100 | 420 | 15 - 125 | 500 - 150 | 2.5 - 2.0 | 550° C |
| AlCrN | 200 | -- | 200 | -- | -100 | -- | -- | 1000 | 2.6 | 550° C |
| AlMeN | 140 | -- | 140 | -- | -80 | -- | -- | 600 | 0.8 | 500° C |
| AlMeCN | 220 | | 220 | | -120 | 300 | 10-150 | druckgeregelt | 2.5 | 600° C |

Spulenstrom des Quellenmagnetsystems 0.1 bis 2 A

**Patentansprüche**

1. *Werkstück mit einem PVD Schichtsystem, wobei das PVD Schichtsystem zumindest eine Mischkristallschicht eines Mehrfachoxids folgender Zusammensetzung umfasst:*

$$(Me1_{1-x}Me2_x)_2O_3$$

*wobei Me1 Al und Me 2 zumindest eines der Elemente Cr, Fe, Li, Mg, Mn, Nb, Ti, Sb oder V umfasst, wobei $0.2 \leq x \leq 0.98$ ist,*
*dadurch gekennzeichnet, dass das Kristallgitter der Mischkristallschicht eine Korundstruktur aufweist, die in einem mittels Röntgendiffraktometrie gemessenen Spektrum der Mischkristallschicht durch mindestens vier, bevorzugt fünf der Korundstruktur zuzuordnenden Linien charakterisiert ist, und dass das Schichtsystem mittels Arcverfahren hergestellt ist.*

2. *Werkstück nach Anspruch 1, dadurch gekennzeichnet, dass die Korundstruktur der Mischkristallschicht thermisch so stabil ist, dass sich der Gitterparameter a und/oder c der Mischkristallschicht auch nach 30 Minuten Tempern an Luft bei zumindest 1000° C, bzw. bei zumindest 1100° C um maximal 2 %, bevorzugt um maximal 1 % verschiebt, und/oder*

   *• die Mischkristallschicht einen stöchiometrischen oder substöchiometrischen Sauerstoffgehalt aufweist, wobei der Sauerstoffgehalt 0 bis 15 %-Punkte, bevorzugt 0 bis 10 %-Punkte unter der stöchiometrischen Zusammensetzung der Verbindung liegt, und/oder*
   *• die Mischkristallschicht feinkristallin mit einer mittleren Kristallitgrösse kleiner 0.2 $\mu$m, bevorzugt kleiner 0.1 $\mu$m liegt, und/oder*
   *• $0.3 \leq x \leq 0.95$ ist, und/oder*
   *• die Mischkristallschicht einen Gehalt an Edelgas und Halogenen von jeweils weniger als 2 at% aufweist, dass dabei weiter vorzugsweise*
   *• der Gehalt an Edelgas in der Mischkristallschicht maximal 0,1 at%, bevorzugt maximal 0,05 at% ist und / oder derjenige der Halogene maximal 0,5 at%, bevorzugt maximal 0,1 at% ist, bzw. die Mischkristallschicht bevorzugt*

*im Wesentlichen kein Edelgas und / oder Halogen enthält.*

3. *Werkstück nach Anspruch 1, **dadurch gekennzeichnet, dass** die Schichtspannung der Mischkristallschicht so gering ist, dass die Abweichung der Gitterparameter der Mehrfachoxide von dem durch das Vegardsche Gesetz bestimmten Wert kleiner oder gleich 1 %, bevorzugt kleiner oder gleich 0.8 % ist.*

4. *Werkstück nach einem der vorhergehenden Ansprüche, **dadurch gekennzeichnet, dass** die an einer 2 $\mu$m dicken Mischkristallschicht gemessene Schichtspannung eine Druck- oder Zugspannung mit einem Wert kleiner $\pm0.8$ GPa, bevorzugt kleiner $\pm0.5$ GPa ist, und/oder*

   • *die Mischkristallschicht eine Mehrlagenschicht aus zumindest zwei verschiedenen alternierend abgeschiedenen Mehrfachoxiden umfasst, und/oder*
   • *die Mischkristallschicht eine Mehrlagenschicht aus zumindest einem Mehrfachoxid sowie einem weiteren Oxid in alternierender Reihenfolge umfasst, wobei*

      i. *das Mehrfachoxid ein Doppeloxid, insbesondere $(AlCr)_2O_3$ oder $(AlV)_2O_3$ ist, und*
      ii. *das weitere Oxid ein Oxid in Korundstruktur, wie $Cr_2O_3$, $V_2O_3$, $Fe_2O_3$, $FeTiO_3$, $MgTiO_2$ oder $\alpha$-$Al_2O_3$ ist.*

5. *Werkstück nach einem der vorhergehenden Ansprüche, **dadurch gekennzeichnet, dass** zusätzlich zur Mischkristallschicht zumindest eine Zwischenschicht, insbesondere eine Haftschicht und/oder eine Hartschicht, zwischen Werkstück und Mischkristallschicht und / oder eine Deckschicht auf der Mischkristallschicht angeordnet ist und diese vorzugsweise eines der Metalle der Nebengruppen IV, V, und VI des Periodensystems und /oder Al, Si, Fe, Ni, Co, Y, La oder eine Mischung von diesen enthalten, dass vorzugsweise dabei*

   • *die Metalle der Hartschicht und / oder der Deckschicht Verbindungen mit N, C, O, B sind oder Mischungen davon, wobei die Verbindung mit N, bzw. CN bevorzugt sind, und/oder*
   • *die Hartschicht TiN, TiCN, AlTiN, AlTiCN, AlCrN bzw. AlCrCN und die Deckschicht AlCrN, AlCrCN, $Cr_2O_3$ oder $Al_2O_3$, insbesonder $\gamma$-$Al_2O_3$ oder $\alpha$-$Al_2O_3$ umfasst, und/oder*
   • *die Zwischenschicht und / oder die Hartschicht eine Mehrlagenschicht umfasst, und/oder*
   • *Zwischenschicht und Mischkristallschicht bzw. Deckschicht und Mischkristallschicht als alternierende Mehrlagenschicht angeordnet sind, und/oder*
   • *das Schichtsystem eine Gesamtschichtdicke von grösser 10 $\mu$m, bevorzugt grösser 20 $\mu$m aufweist, und/oder*
   • *die Mischkristallschicht eine Schichtdicke von grösser 5 $\mu$m, bevorzugt grösser 8 $\mu$m aufweist.*

6. *Vakuumbeschichtungsverfahren zur Herstellung einer Mischkristallschicht eines Mehrfachoxids nach Anspruch 1 auf einem Werkstück mittels Arcverfahren, wobei eine elektrische Bogenentladung zwischen mindestens einer Anode und einer als Target ausgeführten Kathode einer Arcquelle, in einem sauerstoffhaltigen Prozessgas betrieben wird, wobei an der Oberfläche des Targets kein oder nur ein kleines, im Wesentlichen zur Targetoberfläche senkrechtes, äusseres Magnetfeld, umfassend eine senkrechte Komponente Bz sowie eine im Wesentlichen kleinere radiale oder oberflächenparallele Komponente Br, zur Unterstützung des Verdampfungsprozesses erzeugt wird, wobei das Target ein Legierungstarget ist, das im Wesentlichen der Zusammensetzung der Mischkristallschicht entspricht und diese in Korundstruktur abgeschieden wird.*

7. *Verfahren nach Anspruch 6, **dadurch gekennzeichnet, dass** sich die Zusammensetzung der Metalle der Mischkristallschicht, nach Normierung auf den Gesamtmetallgehalt, bezüglich der entsprechenden Metallanteile um nicht mehr als 10 bevorzugt um nicht mehr als 5, insbesondere nicht mehr als 3 Prozent vom Gehalt der Targetzusammensetzung unterscheidet, und vorzugsweise*

   • *die senkrechte Komponente $B_z$ an der Targetoberfläche zwischen 3 und 50, bevorzugt jedoch zwischen 5 und 25 Gauss eingestellt wird, und/oder*
   • *zur Erzeugung des kleinen Magnetfelds, ein aus zumindest einer axial gepolten Spule bestehendes Magnetsystem, das eine dem Targetumfang ähnliche Geometrie aufweist, mit einem Erregerstrom beaufschlagt wird, und/oder*
   • *die Funkenentladung, bzw. die zumindest eine Arcquelle gleichzeitig mit einem Gleichstrom als auch mit einem Puls- bzw. Wechselstrom gespeist wird.*

8. *Vakuumbeschichtungsverfahren zur Herstellung einer Mischkristallschicht eines Mehrfachoxids nach Anspruch 1 auf einem Werkstück mittels Arcverfahren, indem in einem sauerstoffhaltigen Prozessgas, mit einer als Target*

*ausgeführten ersten Elektrode einer Arcquelle sowie mit einer zweiten Elektrode eine Schicht auf das Werkstück abgeschieden wird, wobei die Quelle gleichzeitig mit einem Gleichstrom bzw. Gleichspannung als auch mit einem Puls- oder Wechselstrom bzw. einer Puls- oder Wechselspannung gespeist wird, wobei das Target ein Legierungstarget ist, das im Wesentlichen der Zusammensetzung der Mischkristallschicht entspricht und diese in Korundstruktur abgeschieden wird.*

**9.** *Verfahren nach Anspruch 8, **dadurch gekennzeichnet, dass** sich die Zusammensetzung der Metalle der Mischkristallschicht, nach Normierung auf den Gesamtmetallgehalt, bezüglich der entsprechenden Metallanteile um nicht mehr als 10 at%, bevorzugt um nicht mehr als 5 at%, insbesondere nicht mehr als 3 at% vom Gehalt der Targetzusammensetzung unterscheidet, und/oder*

- *die zweite Elektrode von der Arcquelle getrennt oder*
- *als Anode der Arcquelle angeordnete ist, wobei*

  - *i. beide Elektroden mit einer einzelnen Pulsstromversorgung verbunden, betrieben werden, und*
  - *ii. die zweite Elektrode als Kathode einer weiteren Arcverdampferquelle betrieben wird und diese ebenfalls mit einer DC-Stromversorgung verbunden, betrieben wird, oder*

- *die zweite Elektrode als Verdampfungstiegel ausgebildet ist und als die Anode eines Niedervoltbogenverdampfers betrieben wird, oder*
- *die DC-Stromversorgung und die Pulsstromversorgung mit einem elektrischen Entkopplungsfilter entkoppelt wird, wobei dieses vorzugsweise mindestens eine Sperrdiode enthält, und/oder*
- *die DC-Stromversorgung mit einem Grundstrom betrieben wird, derart dass die Plasmaentladung an den Quellen im Wesentlichen unterbrechungsfrei aufrecht erhalten wird, insbesondere an den Arcverdampferquellen, und/oder*
- *die Pulsstrom- bzw. Pulsspannungsversorgung mit Pulsflanken betrieben wird, die Steilheiten aufweisen grösser 2,0 V/ns, dass sie vorzugsweise mindestens im Bereich von 0,02 V/ns bis 2,0 V/ns liegen, vorzugsweise mindestens im Bereich von 0,1 V/ns bis 1,0 V/ns liegen und eine Hochleistungsentladung entsteht, und/oder,*
- *die Pulsstromversorgung mit einer Frequenz im Bereich von 1kHz bis 200kHz betrieben wird, und/oder*
- *die Pulsstromversorgung mit einem unterschiedlichen Pulsbreitenverhältnis eingestellt, betrieben wird.*

**10.** *Verfahren nach einem der Ansprüche 8 oder 9, **dadurch gekennzeichnet, dass** ein gepulstes Magnetfeld an zumindest eine Arcquelle angelegt wird, dabei bevorzugt,*

- *das Magnetfeld durch den Pulsstrom oder einem Teil des Pulstroms der Arcquelle gepulst wird.*

**11.** *Verfahren nach einem der Ansprüche 8 bis 10, **dadurch gekennzeichnet, dass** zumindest eine Arcquelle nicht gekühlt ist oder beheizt wird.*

**12.** *Verfahren nach einem der Ansprüche 8 bis 11, **dadurch gekennzeichnet, dass** die Quellen mit einem Prozessgas betrieben werden welches zumindest zu 80%, bevorzugt zu 90% insbesondere bevorzugt zu 100% aus Sauerstoff besteht.*

**13.** *Verfahren nach einem der Ansprüche 8 bis 12, **dadurch gekennzeichnet, dass** die Beschichtungstemperatur kleiner 650°C, bevorzugt kleiner 550°C eingestellt wird, und bevorzugt*

- *das Grundmaterial des Werkzeugs zumindest in den dem Verschleiss ausgesetzten Bereichen ein Werkzeugstahl, HSS, ein PM-Stahl oder ein HM-, Cermet- oder CBN-Sinterwerkstoffen ist, und das Grundmaterial des Bauteils zumindest in den dem Verschleiss ausgesetzten Bereichen ein Kaltarbeitsstahl, HSS, ein PM-Stahl oder ein HM-, Cermet-, SiC-, SiN- oder CBN-Sinterwerkstoffen, oder polykristaliner Diamant ist, oder*
- *ein Schneidwerkzeug, insbesondere eine Wendeschneidplatte aus HSS, HM, Cermet, CBN, SiN, SiC oder einem PM-Stahl, oder eine diamantbeschichtete Wendeschneidplatte ist, oder*
- *ein Umformwerkzeug, insbesondere ein Schmiedewerkzeug ist, oder*
- *ein Spritzgiesswerkzeug ist, oder*
- *das Bauteil eine Komponente eines Verbrennungsmotors, insbesondere eine Einspritzdüse, ein Kolbenring, ein Tassenstössel, ein Turbinenblatt ist.*

**14.** *Werkstück mit einem PVD Schichtsystem gemäss einem der Ansprüche 1 bis 6 für den Einsatz bei hohen Tempe-*

*raturen und/oder hoher chemischer Belastung **dadurch gekennzeichnet, dass** es ein Werkzeug oder ein Bauteil ist.*

**Claims**

1. A workpiece having a PVD layer system, wherein the PVD layer system comprises at least one mixed crystal layer of a multi-oxide of the following composition:

$$(Me1_{1-x}Me2_x)_zO_3$$

wherein Me1 comprises Al and Me2 comprises at least one of the elements Cr, Fe, Li, Mg, Mn, Nb, Ti, Sb, or V, wherein $0.2 \leq x \leq 0.98$,
**characterized in that** the crystal lattice of the mixed crystal layer has a corundum structure, which is **characterized, in** a spectrum of the mixed crystal layer measured by means of x-ray diffractometry, by at least four, preferably five lines to be associated with the corundum structure, and the layer system is produced by means of arc methods.

2. The workpiece according to Claim 1, **characterized in that** the corundum structure of the mixed crystal layer is sufficiently thermally stable that the lattice parameter a and/or c of the mixed crystal layer shifts by at most 2%, preferably by at most 1% even after 30 minutes of tempering in air at at least 1000°C, or at at least 1100°C, respectively, and/or

   - the mixed crystal layer has a stoichiometric or substoichiometric oxygen content, wherein the oxygen content is 0 to 15 percentage points, preferably 0 to 10 percentage points below the stoichiometric composition of the compound, and/or
   - the mixed crystal layer is fine-crystalline having a mean crystallite size less than 0.2 $\mu$m, preferably less than 0.1 $\mu$m, and/or
   - $0.3 \leq x \leq 0.95$, and/or
   - the mixed crystal layer has a content of noble gas and halogens of less than 2 atomic-% each, and in this case preferably furthermore
   - the content of noble gas in the mixed crystal layer is at most 0.1 atomic-%, preferably at most 0.05 atomic-%, and/or that of the halogens is at most 0.5 atomic-%, preferably at most 0.1 atomic-%, or the mixed crystal layer preferably contains essentially no noble gas and/or halogen, respectively.

3. The workpiece according to Claim 1, **characterized in that** the layer stress of the mixed crystal layer is sufficiently low that the deviation of the lattice parameter of the multi-oxides from the value determined by Vegard's law is less than or equal to 1%, preferably less than or equal to 0.8%.

4. The workpiece according to any one of the preceding claims, **characterized in that** the layer stress measured on a 2-$\mu$m-thick mixed crystal layer is a compressive or tensile stress having a value less than $\pm$ 0.8 GPa, preferably less than $\pm$ 0.5 GPa, and/or

   - the mixed crystal layer comprises a multi-ply layer made of at least two different, alternately deposited multi-oxides, and/or
   - the mixed crystal layer comprises a multi-ply layer made of at least one multi-oxide and one further oxide in alternating sequence, wherein

      i. the multi-oxide is a double oxide, in particular $(AlCr)_2O_3$ or $(AlV)_2O_3$, and
      ii. the further oxide is an oxide in corundum structure, such as $Cr_2O_3$, $V_2O_3$, $Fe_2O_3$, $FeTiO_3$, $MgTiO_2$, or $\alpha$-$Al_2O_3$.

5. The workpiece according to any one of the preceding claims, **characterized in that,** in addition to the mixed crystal layer, at least one intermediate layer, in particular an adhesive layer and/or a hard layer, is arranged between workpiece and mixed crystal layer, and/or a cover layer is arranged on the mixed crystal layer and these preferably contain one of the metals of the subgroups IV, V, and VI of the periodic system and/or Al, Si, Fe, Ni, Co, Y, La or a mixture thereof, and preferably in this case

   - the metals of the hard layer and/or the cover layer are compounds having N, C, O, B, or mixtures thereof, wherein the compounds having N or CN are preferred, and/or

- the hard layer comprises TiN, TiCN, AlTiN, AlTiCN, AlCrN, and/or AlCrCN and the cover layer comprises AlCrN, AlCrCN, $Cr_2O_3$, or $Al_2O_3$, in particular, $\gamma$-$Al_2O_3$ or $\alpha$-$Al_2O_3$, and/or
- the intermediate layer and/or the hard layer comprises a multi-ply layer, and/or
- intermediate layer and mixed crystal layer or cover layer and mixed crystal layer, respectively, are arranged as an alternating multi-ply layer, and/or
- the layer system has a total layer thickness of greater than 10 $\mu$m, preferably greater than 20 $\mu$m, and/or
- the mixed crystal layer has a layer thickness of greater than 5 $\mu$m, preferably greater than 8 $\mu$m.

6. A vacuum coating method for producing a mixed crystal layer of a multi-oxide according to Claim 1 on a workpiece by means of arc methods, wherein an electric arc discharge is operated in an oxygenated process gas between at least one anode and one cathode, embodied as a target of an arc source, wherein no or only a small external magnetic field essentially perpendicular to the target surface, comprising a perpendicular component Bz and a substantially smaller radial or surface-parallel component Br is generated on the surface of the target to assist the vaporization process, wherein the target is an alloy target which substantially corresponds to the composition of the mixed crystal layer and it is deposited in corundum structure.

7. The method according to Claim 6, **characterized in that** the composition of the metals of the mixed crystal layer, after scaling to the total metal content, differs with respect to the corresponding metal proportions by not more than 10%, preferably by not more than 5%, in particular not more than 3% from the content of the target composition, and preferably

- the perpendicular component Bz is set at the target surface to between 3 and 50, but preferably between 5 and 25 Gauss, and/or
- to generate the small magnetic field, an exciter current is applied to a magnet system consisting of at least one axially polarized coil, which has a geometry similar to the target circumference, and/or
- the arc discharge or the at least one arc source, respectively, is fed simultaneously with a direct current and also with a pulsed or alternating current.

8. A vacuum coating method for producing a mixed crystal layer of a multi-oxide according to Claim 1 on a workpiece by means of arc methods, by a layer being deposited on the workpiece in an oxygenated process gas using a first electrode of an arc source, embodied as a target, and using a second electrode, wherein the source is fed simultaneously with a direct current or DC voltage and also with a pulsed or alternating current or a pulsed voltage or AC voltage, wherein the target is an alloy target, which essentially corresponds to the composition of the mixed crystal layer and it is deposited in corundum structure.

9. The method according to Claim 8, **characterized in that** the composition of the metals of the mixed crystal layer, after scaling to the total metal content, differs with respect to the corresponding metal proportions by not more than 10 atomic-%, preferably by not more than 5 atomic-%, in particular by not more than 3 atomic-% from the content of the target composition, and/or

- the second electrode is arranged separated from the arc source or
- is arranged as an anode of the arc source, wherein

i. both electrodes are operated connected to a single pulsed current supply, and
ii. the second electrode is operated as a cathode of a further arc vaporizer source and this is also operated connected to a DC current supply, or

- the second electrode is designed as a vaporization crucible and is operated as the anode of a low voltage arc vaporizer, or
- the DC current supply and the pulsed current supply are decoupled using a decoupling filter, wherein this filter preferably contains at least one blocking diode, and/or
- the DC current supply is operated using a base current in such a way that the plasma discharge is maintained at the sources essentially without interruption, in particular at the arc vaporizer sources, and/or
- the pulsed current or pulsed voltage supply is operated using pulse flanks which have slopes greater than 2.0 V/ns, preferably at least in the range of 0.02 V/ns to 2.0 V/ns, preferably at least in the range of 0.1 V/ns to 1.0 V/ns and a high power discharge results, and/or
- the pulsed current supply is operated at a frequency in the range of 1 kHz to 200 kHz, and/or
- the pulsed current supply is operated set at a different pulse width ratio.

**10.** The method according to any one of Claims 8 or 9, **characterized in that** a pulsed magnetic field is applied to at least one arc source, in this case preferably

- the magnetic field is pulsed by the pulsed current or a part of the pulsed current of the arc source.

**11.** The method according to any one of Claims 8 to 10, **characterized in that** at least one arc source is not cooled or is heated.

**12.** The method according to any one of Claims 8 to 11, **characterized in that** the sources are operated using a process gas which consists at least up to 80%, preferably up to 90%, in particular preferably up to 100% of oxygen.

**13.** The method according to any one of Claims 8 to 12, **characterized in that** the coating temperature is set less than 650°C, preferably less than 550°C, and preferably

- the base material of the tool, at least in the region subject to wear, is a tool steel, HSS, a PM steel, or an HM, cermet, or CBN sintered material, and the base material of the component, at least in the regions subject to wear, is a cold-worked steel, HSS, a PM steel, or an HM, cermet, SiC, SiN, or CBN sintered material, or polycrystalline diamond, or
- is a cutting tool, in particular an indexable insert made of HSS, HM, cermet, CBN, SiN, SiC, or a PM steel, or is a diamond-coated indexable insert, or
- is a forming tool, in particular a forging tool, or
- is an injection mold, or
- the part is a component of an internal combustion engine, in particular an injection nozzle, a piston ring, a bucket tappet, or a turbine blade.

**14.** A workpiece having a PVD layer system according to any one of Claims 1 to 6 for use at high temperatures and/or under high chemical strain, **characterized in that** it is a tool or a part.

**Revendications**

**1.** Pièce usinée avec un système de couches de type PVD, le système de couches de type PVD comprenant au moins une couche de cristal mixte d'un oxyde multiple de composition suivante

$$(Me1_{1-x}Me2_x)_2O_3$$

Me1Al et Me2 comprenant au moins un des éléments Cr, Fe, Li, Mg, Mn, Nb, Ti, Sb ou V, où $0,2 \leq x \leq 0,98$, **caractérisée en ce que** le réseau cristallin de la couche de cristal mixte présente une structure de type corindon, qui est caractérisée, dans un spectre de la couche de cristal mixte mesuré par diffractométrie des rayons X, par au moins quatre, de préférence cinq lignes attribuables à la structure de type corindon, et **en ce que** le système de couches est fabriqué par procédé à l'arc.

**2.** Pièce usinée selon la revendication 1, **caractérisée en ce que** la structure de type corindon de la couche de cristal mixte est thermiquement stable de sorte que le paramètre de réseau a et/ou c de la couche de cristal mixte, même après 30 minutes de trempe à l'air à au moins 1000 °C, ou au moins 1100 °C, se déplace de maximum 2 %, de préférence de maximum 1 %, et/ou

- la couche de cristal mixte présente une teneur en oxygène stoechiométrique ou sous-stoechiométrique, la teneur en oxygène allant de 0 à 15 points de pourcentage, de préférence de 0 à 10 points de pourcentage pour la composition stoechiométrique du composé, et/ou
- la couche de cristal mixte est dans le microcristallin avec une taille moyenne de cristallite inférieure à 0,2 $\mu$m, de préférence inférieure à 0,1 $\mu$m, et/ou
- $0,3 \leq x \leq 0,95$, et/ou
- la couche de cristal mixte présente une teneur en gaz rare et en halogène inférieure à 2 % atomique, de sorte que de préférence
- la teneur en gaz rare dans la couche de cristal mixte est de maximum 0,1 % atomique, de préférence de maximum 0,05 % atomique et/ou la teneur en halogène est de maximum 0,5 % atomique, de préférence de maximum 0,1 % atomique, ou la couche de cristal mixte ne présente essentiellement aucun gaz rare et/ou halogène.

**3.** Pièce usinée selon la revendication 1, **caractérisée en ce que** la contrainte de la couche de cristal mixte est si faible que l'écart entre le paramètre de réseau de l'oxyde multiple et la valeur définie par la loi de Vegard est inférieur ou égal à 1 %, de préférence inférieur ou égal à 0,8 %.

**4.** Pièce usinée selon l'une des revendications précédentes, **caractérisée en ce que** la contrainte de couche mesurée sur une couche de cristal mixte de 2 $\mu$m d'épaisseur est une contrainte de compression ou de traction avec une valeur inférieure à $\pm$ 0,8 GPa, de préférence inférieure à $\pm$ 0,5 GPa, et/ou

- la couche de cristal mixte comprend une couche multicouche composée d'au moins deux oxydes multiples différents séparés en alternance, et/ou
- la couche de cristal mixte comprend une couche multicouche composée d'au moins un oxyde multiple et d'un autre oxyde en ordre alterné, où

i. l'oxyde multiple est un oxyde double, en particulier $(AlCr)_2O_3$ ou $(AlV)_2O_3$, et
ii. l'autre oxyde est un oxyde dans la structure de type corindon, tel que $Cr_2O_3$, $V_2O_3$, $Fe_2O_3$, $FeTiO_3$, $MgTiO_2$ ou $\alpha$-$Al_2O_3$.

**5.** Pièce usinée selon l'une des revendications précédentes, **caractérisée en ce que**, en plus de la couche de cristal mixte, il est agencé au moins une couche intermédiaire, en particulier une couche adhésive et/ou une couche dure, entre la pièce usinée et la couche de cristal mixte et/ou une couche de recouvrement sur la couche de cristal mixte, et **en ce que** ces dernières comprennent de préférence un des métaux des sous-groupes IV, V et VI du tableau périodique et/ou Al, Si, Fe, Ni, Co, Y, La ou un mélange de ces derniers, de sorte que de préférence

- les métaux de la couche dure et/ou de la couche de recouvrement sont des composés avec N, C, O, B ou des mélanges de ces derniers, le composé avec N ou CN étant préférée, et/ou
- la couche dure comprend TiN, TiCN, AlTiN, AlTiCN, AlCrN ou AlCrCN et la couche de recouvrement AlCrN, AlCrCN, $Cr_2O_3$ ou $Al_2O_3$, en particulier $\gamma$-$Al_2O_3$ ou $\alpha$-$Al_2O_3$, et/ou
- la couche intermédiaire et/ou la couche dure comprend une multicouche, et/ou
- la couche intermédiaire et la couche de cristal mixte ou la couche de recouvrement et la couche de cristal mixte sont agencées en multicouches alternées, et/ou
- le système de couche présente une épaisseur de couche totale supérieure à 10 $\mu$m, de préférence supérieure à 20 $\mu$m, et/ou
- la couche de cristal mixte présente une épaisseur de couche supérieure à 5 $\mu$m, de préférence supérieure à 8 $\mu$m.

**6.** Procédé de revêtement sous vide pour fabriquer une couche de cristal mixte d'un oxyde multiple selon la revendication 1 sur une pièce usinée par procédé à l'arc, dans lequel il est réalisé dans un gaz de procédé contenant de l'oxygène une décharge en arc entre au moins une anode et une cathode d'une source d'arc réalisée comme une cible, dans lequel il n'est produit à la surface de la cible aucun champ magnétique ou qu'un petit champ magnétique extérieur, essentiellement perpendiculaire à la surface cible, comprenant une composante perpendiculaire Bz ainsi qu'une composante Br essentiellement plus petite, radiale ou parallèle en surface pour favoriser le processus d'évaporation, la cible étant une cible d'alliage qui correspond pour l'essentiel à la composition de la couche de cristal mixte et qui est séparée dans la structure de corindon.

**7.** Procédé selon la revendication 6, **caractérisé en ce que** la composition des métaux de la couche de cristal mixte, après normalisation de la teneur totale en métaux, en ce qui concerne les éléments métalliques correspondants, ne diffère pas de plus de 10, de préférence de plus de 5, en particulier de plus de 3 pour cent de la teneur de la composition cible, et de préférence

- la composante perpendiculaire Bz sur la surface cible est réglée entre 3 et 50, de préférence toutefois entre 5 et 25 Gauss, et/ou
- pour produire le petit champ magnétique, un système d'aimant composé d'au moins une bobine polarisée axialement et présentant une géométrie similaire au contour de la cible, est alimenté avec un courant d'excitation, et/ou
- la décharge par étincelle ou la au moins une source d'arc est alimentée en même temps avec un courant continu et avec un courant pulsé ou alternatif.

**8.** Procédé de revêtement sous vide pour fabriquer une couche de cristal mixte d'un oxyde multiple selon la revendication 1 sur une pièce usinée par procédé à l'arc, dans lequel, dans un gaz de procédé contenant de l'oxygène, on sépare, avec une première électrode d'une source d'arc réalisée comme cible et une deuxième électrode, une couche sur la pièce usinée, la source étant alimentée en même temps avec un courant continu ou une tension continue et avec un courant pulsé ou alternatif ou une tension pulsée ou alternative, la cible étant une cible d'alliage qui correspond pour l'essentiel à la composition de la couche de cristal mixte et qui est séparée dans la structure de corindon.

**9.** Procédé selon la revendication 8, **caractérisé en ce que** la composition des métaux de la couche de cristal mixte, après normalisation de la teneur totale en métaux, en ce qui concerne les éléments métalliques correspondants, ne diffère pas de plus de 10 % atomique, de préférence de plus de 5 % atomique, en particulier de plus de 3 % atomique de la teneur de la composition cible, et/ou

- la deuxième électrode est séparée de la source d'arc ou
- est agencée comme anode de la source d'arc,

    i. les deux électrodes étant utilisées, raccordées, avec une seule alimentation pulsée, et
    ii. la deuxième électrode étant utilisée comme cathode d'une autre source d'évaporateur à arc et cette dernière étant également utilisée raccordée à une alimentation DC, ou

- la deuxième électrode est réalisée comme creuset d'évaporation et est utilisée comme l'anode d'un évaporateur à arc basse tension, ou
- l'alimentation DC et l'alimentation pulsée sont découplées avec un filtre de découplage électrique, ce dernier contenant de préférence au moins une diode de blocage, et/ou
- l'alimentation DC fonctionne avec un courant de base de sorte que la décharge de plasma au niveau des sources est maintenue essentiellement sans interruption, en particulier au niveau des sources d'évaporateur à arc, et/ou
- l'alimentation de courant pulsé ou de tension pulsée fonctionne avec des flancs d'impulsion, qui présentent des pentes supérieures à 2,0 V/ns de sorte qu'elles sont de préférence au moins dans la plage allant de 0,02 V/ns à 2,0 V/ns, de préférence au moins dans la plage allant de 0,1 V/ns à 1,0 V/ns et il en résulte une décharge haute performance, et/ou
- l'alimentation pulsée fonctionne avec une fréquence dans la plage de 1 kHz à 200 kHz, et/ou
- l'alimentation pulsée fonctionne réglée avec un rapport de largeurs d'impulsion différent.

**10.** Procédé selon l'une des revendications 8 ou 9, **caractérisé en ce qu'**un champ magnétique pulsé est appliqué à au moins une source d'arc,

- le champ magnétique étant de préférence pulsé par le courant pulsé ou une partie du courant pulsé de la source d'arc.

**11.** Procédé selon l'une des revendications 8 à 10, **caractérisé en ce qu'**au moins une source d'arc n'est pas refroidie ou est chauffée.

**12.** Procédé selon l'une des revendications 8 à 11, **caractérisé en ce que** les sources fonctionnent avec un gaz de procédé qui est constitué au moins à 80 %, de préférence à 90 %, de façon particulièrement préférée à 100 % d'oxygène.

**13.** Procédé selon l'une des revendications 8 à 12, **caractérisé en ce que** la température de revêtement est inférieure à 650 °C, de préférence inférieure à 550 °c, et de préférence

- le matériau de base de l'outil est, au moins dans les zones soumises à l'usure, un acier à outil, HSS, un acier PM ou un matériau fritté HM, cermet ou CBN, et le matériau de base du composant, au moins dans les zones soumises à l'usure, est un acier pour travail à froid, HSS, un acier PM ou un matériau fritté HM, cermet, SiC, SiN ou CBN, ou un diamant polycristallin, ou
- est un outil de coupe, en particulier une plaquette de coupe amovible en HSS, HM, Cermet, CBN, SiN, SiC ou un acier PM, ou une plaquette de coupe amovible à revêtement diamant, ou
- est un outil de formage, en particulier un outil de forge, ou
- est un outil de moulage par injection, ou

- est l'élément d'une composante d'un moteur à combustion, en particulier un injecteur, un segment de piston, un poussoir de soupape, une pale de turbine.

**14.** Pièce usinée avec un système de couche de type PVD selon l'une des revendications1 à 6 destinée à être utilisée à hautes températures et/ou sous contrainte chimique élevée, **caractérisée en ce qu'**il s'agit d'un outil ou d'un composant.

Fig.1A

EP 2 082 079 B1

A l / C r  2 5 / 7 5

Fig.1B

EP 2 082 079 B1

Al/Cr 50/50

Fig.1C

A l / C r 7 0 / 3 0

EP 2 082 079 B1

**Fig.2**

**Fig.3**

Fig.4

H 3 = 140 nm

H 1 = 130 nm

H 4 = 182 nm

H 2 = 154 nm

FN, 900°C, 0.5h, DL

EHT = 5.00 kV   Signal A = InLens   WD = 3 mm   ANM    Mag = 100.00 K X   200nm
File Name = FN-900-0_5h-100k-03.jpg              Date :24 May 2006

Fig.5

Balinit B, 900°C, 30min, DL10

EHT = 5.00 kV   Signal A = InLens   WD = 4 mm   ANM    Mag = 30.00 K X   1μm
File Name = B-900-0_5h-30k-20.jpg              Date :31 May 2006

## Fig.6

RJ, 900°C, 0.5h, DL

EHT = 5.00 kV   Signal A = InLens   WD = 3 mm   ANM       Mag = 50.00 K X   200nm
File Name = RJ-900-0_5h-50k-04.jpg                        Date :24 May 2006

*balzers*

## Fig.7

H 2 = 32 nm

RJ, 900°C, 0.5h, DL

EHT = 5.00 kV   Signal A = InLens   WD = 3 mm   ANM       Mag = 150.00 K X   100nm
File Name = RJ-900-0_5h-150k-07.jpg                       Date :24 May 2006

*balzers*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0513662 A
- US 5310607 A
- US 6767627 B
- JP 2002053946 A
- JP 5208326 A
- US 20050058850 A
- WO 2004097062 A
- EP 0744473 B1

- JP 2000129445 A
- US 2004121147 A1
- EP 0744473 A
- US 2004202877 A
- WO 2006099758 A
- WO 2006099760 A
- CH 0116606
- DE 19522331

**In der Beschreibung aufgeführte Nicht-Patentliteratur**

- **ASHENFORD.** *Surface and Coatings Technology,* 1999, vol. 116-119, 699-704

- Phase Equilibria Diagrams Volume XII Oxides. **W.SITTE.** Mater.Sci.Monogr., 28A, React. Solids. American Ceramic Society, 1985, vol. 28A, 451-456